(19) Europäisches Patentamt
European Patent Office
Office européen des brevets

(11) **EP 4 479 762 B1**

(12) **EUROPÄISCHE PATENTSCHRIFT**

(45) Veröffentlichungstag und Bekanntmachung des Hinweises auf die Patenterteilung:
**02.07.2025 Patentblatt 2025/27**

(21) Anmeldenummer: **23725141.8**

(22) Anmeldetag: **03.05.2023**

(51) Internationale Patentklassifikation (IPC):
**G01R 33/38** (2006.01)    **G01R 33/3815** (2006.01)
**H01F 6/02** (2006.01)    **H01F 6/04** (2006.01)

(52) Gemeinsame Patentklassifikation (CPC):
**G01R 33/3804; G01R 33/3815; H01F 6/02; H01F 6/04**

(86) Internationale Anmeldenummer:
**PCT/EP2023/061698**

(87) Internationale Veröffentlichungsnummer:
**WO 2023/213895 (09.11.2023 Gazette 2023/45)**

(54) **AUTONOME STROMBELADUNG EINES SUPRALEITFÄHIGEN, TROCKEN-GEKÜHLTEN MR-MAGNETSPULENSYSTEMS**

AUTONOMOUS CURRENT CHARGING OF A SUPER-CONDUCTIVE, DRY-COOLED MR MAGNET COIL SYSTEM

CHARGE DE COURANT AUTONOME D'UN SYSTÈME DE BOBINE D'ÉLECTRO-AIMANT RM SUPRACONDUCTEUR REFROIDI À SEC

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **06.05.2022 DE 102022204476**

(43) Veröffentlichungstag der Anmeldung:
**25.12.2024 Patentblatt 2024/52**

(73) Patentinhaber: **Bruker BioSpin GmbH & Co. KG 76275 Ettlingen (DE)**

(72) Erfinder:
• **NEUBERTH, Gerald 76646 Bruchsal (DE)**
• **STROBEL, Marco 76137 Karlsruhe (DE)**

(74) Vertreter: **Kohler Schmid Möbus Patentanwälte Partnerschaftsgesellschaft mbB Gropiusplatz 10 70563 Stuttgart (DE)**

(56) Entgegenhaltungen:
WO-A1-2021/215168    DE-B3- 102016 218 000
US-A1- 2005 111 159    US-A1- 2023 046 818
US-B2- 10 060 995

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Betrieb einer Magnetresonanz(="MR")-Apparatur mit einem in einem Vakuumbehälter angeordneten, im MR-Messbetrieb trockenen (="Kryogen-freien"), supraleitfähigen MR-Magnetspulensystem sowie mit einem Kryostaten zum Kühlen des MR-Magnetspulensystems, welcher ein Halsrohr umfasst, das durch einen Außenmantel des Vakuumbehälters hindurch zum MR-Magnetspulensystem führt, wobei ein Kühlarm eines Kaltkopfes zumindest teilweise im Halsrohr angeordnet ist, und wobei das supraleitfähige MR-Magnetspulensystem auf eine supraleitende Temperatur gekühlt wird.

Ein solches Verfahren sowie die zugehörige MR-Apparatur sind bekannt geworden aus der US 10 060 995 B2 (=Referenz [0]). Ein ähnliches Verfahren offenbart die DE 10 2016 218 000 B3 (=Referenz [1]).

Das Verfahren nach Referenz [0] umfasst zudem noch folgende Schritte: Initiieren eines Kühlvorgangs des supraleitfähigen MR-Magnetspulensystems; Initiieren eines automatischen Strombeladungsprogramms für das supraleitfähige MR-Magnetspulensystem;

> Messen der aktuellen Temperatur $T_{coil}$ am MR-Magnetspulensystem und Vergleichen von $T_{coil}$ mit einem vorgebbaren ersten Temperatursollwert $T1_{ramp}$; falls $T_{coil} \leq T1_{ramp}$ Zuführen eines Ladestroms in das MR-Magnetspulensystem und Aufladen des MR-Magnetspulensystems mit elektrischem Strom;
> Messen des aktuell im MR-Magnetspulensystem fließenden elektrischen Stroms $I_{coil}$ und Vergleichen von $I_{coil}$ mit einem vorgebbaren ersten Stromsollwert $I1_{target}$, bei welchem das MR-Magnetspulensystem eine gewünschte Magnetfeldstärke erzeugt;
> Wiederholen der Schritte solange, bis $I_{coil} = I1_{target}$;
> Deaktivieren der Stromzufuhr in das MR-Magnetspulensystem und Stoppen des automatischen Strombeladungsprogramms.

Hintergrund der Erfindung

Die vorliegende Erfindung betrifft allgemein den Bereich der Strombeladung von supraleitenden Magnetanordnungen, welche im Betrieb auf sehr tiefen (=kryogenen) Temperaturen gehalten werden sollen/müssen. Derartige supraleitenden Magnetanordnungen werden etwa auf dem Gebiet der Magnetresonanz, beispielsweise in MRI(=Magnetic Resonance Imaging)-Tomographen oder NMR(= Nuclear Magnetic Resonance)-Spektrometern eingesetzt.

Die Kernspinresonanz ist ein leistungsfähiges Verfahren der instrumentellen Analytik, mit dem insbesondere die chemische Zusammensetzung von Messproben bestimmt werden kann. Dabei werden Hochfrequenz-Pulse in die Messprobe, die sich in einem starken statischen Magnetfeld befindet, eingestrahlt, und die elektromagnetische Reaktion der Probe wird vermessen. Das starke und in der NMR besonders homogene statische Magnetfeld wird in vielen Fällen mittels supraleitender Magnetsysteme erzeugt, welche im Messbetrieb dazu, zumeist unter Zuhilfenahme von flüssigem Helium als kryogenem Fluid, auf sehr niedrige kryogene Temperaturen nahe dem absoluten Nullpunkt gekühlt werden müssen.

Oftmals werden derartige supraleitende Magnetsysteme auch mit einer aktiven Kühlung ausgerüstet. Die Systeme verfügen dann zumeist über gar keinen Fluidtank mehr, in welchem die Magnete unmittelbar von kryogenem Fluid umgeben sind. Vielmehr sind die Spulen der Magnetsysteme in einem Vakuumbehälter angeordnet und mithin im MR-Messbetrieb "trocken", also Kryogen-frei. In der Regel werden den Vakuumbehälter umgebende Strahlungsschilde, mitunter aber auch die Magnetsysteme direkt von einem aktiven Kühler gekühlt, z.B. von einem Pulsrohr-Kühler oder einem Gifford-MacMahon -Kühler.

Diese trockenen Systeme sind generell anfälliger für Störungen des Kühlsystems, wenn beispielsweise der Kaltkopf ausfällt, denn im Gegensatz zu Bad-gekühlten Magnetsystemen ist kein Temperaturpuffer in Form eines das Magnetsystem unmittelbar umgebenden, in der Regel flüssigen Kryogens vorhanden, das bei Ausfall des Kühlsystems abdampfen kann und somit über einen längeren Zeitraum die kryogene Temperatur beibehält. Hingegen erfordern diese Bad-gekühlten Systeme bei der Inbetriebnahme einen größeren Personalaufwand sowie höhere Kosten, weil zum Abkühlen und Befüllen große Mengen (bis zu mehrere 1000 Liter) flüssiges Helium und Stickstoff verwendet werden, welche im Falle eines Quenches erneut nachgefüllt werden müssen. Demgemäß können Bad-gekühlte Systeme niemals autark betrieben werden.

Die Verwendung aktiver Kühlsysteme reduziert insbesondere den Verbrauch an teurem flüssigem Helium, erhöht die Verfügbarkeit der NMR-Apparatur und kann auch zur Reduktion der Baugröße beitragen. Das aktive Kühlsystem kann einstufig oder auch mehrstufig ausgebildet sein. Bei mehrstufigen Systemen kühlt meist eine wärmere Kaltstufe den thermischen Strahlungsschild und eine kältere Kaltstufe das zu kühlende Objekt.

Spezieller Stand der Technik

Die US 8 729 894 B2 (=Referenz [2]) offenbart ein Magnetsystem für die MRI, umfassend einen Behälter mit flüssigem Kryogen darin, sowie einen supraleitenden Magneten innerhalb des Behälters, wobei der Behälter so konfiguriert ist, dass er abnehmbar mit einer Vakuumpumpe verbunden ist, welche ihrerseits so konfiguriert ist, dass sie Kryogen aus dem Behälter pumpt, um ein Druckniveau innerhalb des Behälters während des Hochfahrens des supraleitenden Magneten auf ein abgepumptes Druckniveau zu reduzieren und das Druckniveau von dem abgepumpten Druckniveau auf ein normales Betriebsdruckniveau zu erhöhen Druckniveau während des normalen Magnetbetriebs zu erhöhen. Referenz [2] beschreibt weiterhin ein Verfahren zum Laden des Magneten, wobei während des sogenannten Rampings der Behälter mit dem Magneten evakuiert werden kann. Ein Kaltkopf ist in einem Halsrohr angeordnet, ohne das Vakuum im Behälter zu beeinflussen. Allerdings enthält der Kryostat enthält flüssiges Helium. Hinsichtlich der vorliegenden Erfindung bildet Referenz [2] fernerliegenden Stand der Technik, da es sich um ein "nass gekühltes" Spulensystem handelt, bei welchem ein autarker Betrieb ausgeschlossen ist.

Die US 2005/0111159 A1 (=Referenz [3]) beschreibt ein MRI-Gerät mit einem supraleitenden, wie in Referenz [2] ebenfalls Heliumbad-gekühlten Magneten umfassend eine Technologie zum automatisierten Anlegen von Strom an den Magneten, das automatische Steuern des "ramp-up" auf der Grundlage eines vorbestimmten Wertes eines Zielparameters (Magnetfeldstärke, Stromstärke oder Magnettemperatur). Ein sogenannter "autoramp-controller" steuert das Laden unter Beobachtung der gemessenen Parameter, insbesondere der Temperatur. In diesem Zusammenhang offenbart Referenz [3] ein Verfahren für eine automatische Inbetriebnahme des supraleitenden Magneten. Dabei sollen die Betriebswerte der einschränkenden Parameter gemessen und mit den Sollwerten der einschränkenden Parameter verglichen werden, um die Stromzufuhr zu steuern. Während des Hochlaufs kann die Hochlaufrate in Ampere pro Minute auf der Grundlage des Magnetstroms und der Magnettemperatur gesteuert werden. Der autoramp-controller kann Strom schrittweise hinzufügen, bis ein bestimmter Magnetstrom erreicht ist. Gleichzeitig soll verhindert werden, dass die Magnettemperatur einen vorbestimmten Wert überschreitet.

Jedoch ist in Referenz [3] nicht beschrieben, wie dies bewirkt werden kann. Insbesondere wird in Referenz [3] kein konkreter Lade-Algorithmus offenbart, wie er für die Ladung der sehr sensiblen Supraleiter, die nicht in einem Kühlbad gelagert sind, erforderlich ist, und wodurch ein Abtransport der beim Laden entstehenden Hysterese-Wärme gewährleistet ist. Es wird nur sehr allgemein beschrieben, dass eine Art Kontrolleinheit das Hochfahren überwacht, indem verschiedene Parameter (T und I) gemessen werden. Ein Unterbrechen der Ladung bei zu hoher Magnettemperatur ist nicht vorgesehen. Der autoramp-controller teilt den Ladevorgang im Wesentlichen in zwei Phasen ein, in eine erste Schnell-Ladephase und eine zweite langsamere Ladephase, bei welcher schon Strom auf der Spule und ein Quench somit wahrscheinlicher ist.

Aus der DE 10 2014 218 773 B4 (=Referenz [4]) ist es bekannt, bei einem Kryostaten ein Hohlvolumen zwischen der Innenseite des Halsrohrs und dem Kühlarm eines Kühlkopfes mit einem Gas, etwa Helium, zu füllen. Im Normalbetrieb befindet sich die unterste Kühlstufe des Kühlarms nahe dem zu kühlenden Objekt; beispielsweise wird eine enge thermische Kopplung über einen Kontakt des zu kühlenden Objekts und der untersten Kühlstufe zu einer geringen Menge flüssigen Heliums im Hohlvolumen hergestellt. Bei Ausfall der Kühlung steigt der Gasdruck im Hohlvolumen in Folge der Erwärmung an; etwaiges flüssiges Helium im Hohlvolumen verdampft. Der verschiebbar gelagerte Kühlkopf wird durch den gestiegenen Gasdruck im Hohlvolumen in Richtung vom zu kühlenden Objekt weg bewegt, wodurch die thermische Kopplung von Kühlarm und zu kühlendem Objekt verringert wird. Mit diesem Kryostaten kann die Wärmelast durch einen Kühlarm bei Ausfall der aktiven Kühlung verringert werden, jedoch ist der bauliche Aufwand durch die verfahrbare Aufhängung des Kaltkopfs vergleichsweise groß. Zudem bleibt aufgrund des hohen Gasdrucks im Hohlvolumen weiterhin eine nicht unerhebliche thermische Kopplung bestehen.

Die DE 10 2015 215 919 B4 (= Referenz [5]) beschreibt ein Verfahren und eine Vorrichtung zur Vorkühlung eines Kryostaten mit Heatpipe, wie er etwa in Referenz [4] gezeigt ist. Während einer Vorkühlphase wird das zu kühlende Objekt auf eine Zieltemperatur des Arbeitsbereichs des kryogenen Arbeitsmediums vorgekühlt, in welchem die Heatpipe effizient arbeiten kann, wobei zur Vorkühlung ein gut wärmeleitender, passgenauer Kurzschlussblock durch das Halsrohr in die Heatpipe gesteckt wird, dessen eines freies Ende thermisch mit einer leistungsstarken Kühleinrichtung verbunden ist, dessen anderes Ende die thermische Kontaktfläche berührt. In einer Zwischenphase nach Erreichen der Zieltemperatur wird der Kurzschlussblock aus der Heatpipe entfernt und anschließend während einer Betriebsphase durch die Heatpipe im Kondensationsbetrieb Wärme übertragen. Damit kann die erforderliche Zeit zur Vorkühlung des Kryostaten auf seine Betriebstemperatur signifikant reduziert werden, um so die Dauer der Inbetriebnahme wesentlich zu verkürzen.

Die US 2021/0080527 A1 (= Referenz [6]) beschreibt einen Magnetresonanz-Tomographen mit einem supraleitenden Magneten, der in einem Heliumfreien Kryostaten gelagert ist. Gekühlt wird der Magnet über Heatpipes, die mit Helium betrieben werden und mit einem Kaltkopf verbunden sind. Das Magnetsystem umfasst auch ein sogenanntes intelligentes Überwachungssystem, das eine Echtzeitüberwachung der Betriebszustände gewährleistet, wobei insbesondere die Temperatur (mit T-Sensor) und die externe Stromversorgung überwacht wird. Ein Betriebskontrollsystem kann entsprechende Maßnahmen ergreifen, die das Ansteuern der Wärmeleitungskomponente umfassen, sowie die Ansteuerung der supraleitenden Stromversorgung, um die Magneterregung und Entmagnetisierung durchzuführen. Nicht offenbart ist in diesem Dokument ein autonomes Laden.

Die bereits eingangs zitierte Referenz [1] beschreibt eine Kryostatenanordnung mit einem Vakuumbehälter und einem Kühlobjekt, das innerhalb des Vakuumbehälters angeordnet ist, welcher ein Halsrohr aufweist, das zum Kühlobjekt führt, wobei ein Kühlarm eines Kaltkopfs, um den herum ein abgeschlossener Hohlraum ausgebildet ist, im Halsrohr angeordnet ist, der gegenüber dem Kühlobjekt fluiddicht abgedichtet und im Normalbetrieb mit kryogenem Fluid gefüllt ist. Das Kryogen im Halsrohr kann zur Kühlung unter Vakuum abgedampft und insbesondere bei Ausfall der Kühlfunktion abgepumpt werden, um den Kaltkopf thermisch vom Vakuumbehälter zu entkoppeln. Ein derartiger Kryostat kann zur Durchführung des generischen Verfahrens mit den eingangs definierten Merkmalskomplexen eingesetzt werden. Allerdings wird in Referenz [1] das Beladen einer Magnetspule mit elektrischem Strom nicht einmal andeutungsweise erwähnt, geschweige denn genauer beschrieben.

Nachteilig bei sämtlichen in diesem Zusammenhang bekannten einschlägigen Verfahren zur Strombeladung eines im MR-Messbetrieb trockenen, also nicht von kryogenem Medium umgebenen, supraleitfähigen MR-Magnetspulensystems ist jedoch der Umstand, dass bisher stets und unabdingbar technisches Fachpersonal erforderlich ist.

Ein vollständig autarker Betrieb der MR-Apparatur in dieser Betriebsphase des elektrischen Aufladens der Magnetspulen, die grundsätzlich immer nach der ersten Installation des Systems beim Nutzer, aber auch jedes Mal nach einer zwischenzeitlichen Erwärmung des supraleitfähigen Magneten, etwa bei einem Quench, durchlaufen werden muss, ist ohne die Mitwirkung von kostenintensiven, speziell ausgebildeten Service-Technikern bislang jedenfalls nicht möglich.

Die herkömmliche Vorgehensweise im Stand der Technik beinhaltet also immer und ausschließlich ein manuelles Laden des MR-Magnetspulensystems durch Servicemitarbeiter. Der Ladeplan für den Magneten wir vom Servicetechniker manuell am Netzgerät eingestellt und präpariert. Bei falscher Handhabung des z.T. komplexen Ladeplans können hierbei Fehler entstehen.

Ladeprozesse als solche nehmen zudem sehr viel Zeit in Anspruch, und können mehrere Tage dauern. Das bindet dann entsprechend auch die Arbeitszeit der vor Ort erforderlichen Techniker, denn manuelles Laden erfolgt aus Sicherheitsgründen bis jetzt nur tagsüber. Unachtsamkeiten während des Ladens können zu Fehlern wie. z.B. erhöhter Spulentemperatur oder HTS Ankoppeltemperatur führen. Solche Fehler können einen Quench verursachen oder sogar eine Zerstörung der HTS Stromstäbe herbeiführen.

In der am Anmeldetag der vorliegenden Erfindung noch geheimen und bis dahin nicht publizierten, am 22.06.2021 beim Deutschen Patent- und Markenamt von der Anmelderin eingereichten DE 10 2021 206 392.6 (=Referenz [7]) ist ein autonomes Verfahren beschrieben, um Kryostat-basierte NMR Geräte, insbesondere für die MRI, autonom beim Kunden herunterzukühlen bis auf eine Temperatur, bei der der Magnet -gegebenenfalls wiedergeladen werden kann. Bereits die Erfindung dieses automatischen Kühl-Verfahrens erspart per se den Service Einsatz von Fachpersonal für diesen Zweck. Ein -im Detail sehr komplexes- Ladeprogramm zu einem ebenfalls autonomen elektrischen Beladen des MR-Magnetspulensystems automatisch und gleichfalls ohne aktive Mithilfe von Servicemitarbeitern, ist jedoch in Referenz [7] nicht einmal andeutungsweise offenbart.

Aufgabe der Erfindung

Demgegenüber liegt der vorliegenden Erfindung die -im Detail betrachtet zunächst relativ anspruchsvolle und komplexe- Aufgabe zugrunde, ein Verfahren der eingangs beschriebenen Art zum Betrieb einer MR-Apparatur mit einem "trocken" in einem Vakuumbehälter angeordneten, im MR-Messbetrieb Kryogenfreien, supraleitfähigen MR-Magnetspulensystem sowie mit einem Kryostaten zum Kühlen dieses Systems und auch eine Vorrichtung zur Durchführung dieses Verfahrens mit unaufwändigen, einfach beschaffbaren oder bereits in der Regel standardmäßig beim Anwender vorhandenen technischen Mitteln so zu verbessern, dass ein überwiegend autonomes und auch hinsichtlich bestimmter Prozessparameter gezielt optimierbares, nach dem Starten ("durch Knopfdruck") vollständig automatisch ablaufendes Laden des supraleitfähigen MR-Magnetspulensystems mit elektrischem Strom erfolgen kann, wobei dies auf einfachste Weise und ohne exotische oder teure zusätzliche Komponenten ermöglicht werden soll. Insbesondere soll auch die thermische Belastung durch den Ladevorgang reduziert und die Sicherheit vor einem Quench des Supraleiters erhöht werden.

Das System soll also autark sein, so dass manuelle Eingriffe nicht mehr nötig sind. Außerdem soll eine mögliche Downtime reduziert werden.

Kurze Beschreibung der Erfindung

Diese Aufgabe wird durch die vorliegende Erfindung auf ebenso überraschend einfache wie wirkungsvolle Weise hinsichtlich des Betriebsverfahrens zum autonomen elektrischen Laden des supraleitfähigen MR-Magnetspulensystems gelöst durch folgende Schritte:

(a1) Initiieren eines Kühlvorgangs des supraleitfähigen MR-Magnetspulensystems;

(a2) Initiieren eines automatischen Strombeladungsprogramms für das supraleitfähige MR-Magnetspulensystem;

(b1) Messen der aktuellen Temperatur $T_{coil}$ am MR-Magnetspulensystem und Vergleichen von $T_{coil}$ mit einem vorgebbaren ersten Temperatursollwert $T1_{ramp}$, ab welchem das MR-Magnetspulensystem supraleitend ist und geladen werden soll, wobei in der Regel $T1_{ramp}$ kleiner ist als die kritische Übergangstemperatur $T_c$ am Übergang vom normalleitenden in den supraleitenden Zustand, sowie Messen der aktuellen Temperatur $T_{istshield}$ an einem Strahlungsschild (55) und Vergleichen von $T_{istshield}$ mit einem vorgebbaren ersten Temperatursollwert Tshield;

(b2) falls $T_{coil} \leq T1_{ramp}$ und/oder falls $T_{istshield} \leq T_{shield}$:

Zuführen eines Ladestroms in das MR-Magnetspulensystem und Aufladen des MR-Magnetspulensystems mit elektrischem Strom;

(c) Messen des aktuell im MR-Magnetspulensystem fließenden elektrischen Stroms $I_{coil}$ und Vergleichen von $I_{coil}$ mit einem vorgebbaren ersten Stromsollwert $I1_{target}$, bei welchem das MR-Magnetspulensystem eine gewünschte Magnetfeldstärke erzeugt;

(d) Wiederholen der Schritte (b1), (b2) und (c) solange, bis $I_{coil} = I1_{target}$;

(e) Deaktivieren der Stromzufuhr in das MR-Magnetspulensystem und Stoppen des automatischen Strombeladungsprogramms.

Dadurch, dass in Schritt (b1) zusätzlich die aktuelle Temperatur $T_{istshield}$ an einem Strahlungsschild 55 gemessen und mit einem vorgebbaren Temperatursollwert $T_{shield}$ verglichen wird und falls $T_{istshield} \leq T_{shield}$ der Ladestrom gemäß Schritt (b2) zugeführt wird, kann verhindert werden, dass beim Ladevorgang des Magneten die HTS Stromstäbe ihre kritische Temperatur erreichen und durchbrennen.

Das erfindungsgemäß automatisierte Verfahren zum Laden eines supraleitenden Magneten in Helium-freien Kryostaten umfasst die oben definierten Schritte unter vorgegebenen Ladespannungen und strenger sensorischer -aber automatisch ablaufender- Beobachtung, indem ein genaues Computerprogramm abgefahren wird. Dieser Vorgang wäre beim Laden durch einen Techniker wesentlich variabler, unpräziser und fehleranfällig. Dadurch wird zu jeder Zeit die Betriebssicherheit der Anlage erhöht. Das System wird über Fehlermeldungen überwacht und diese können beispielsweise als Emails an entfernt stationiertes und auch nicht notwendig dauerhaft aktives Überwachungspersonal versendet werden (z.B. "Vorsicht, Gasflaschenfüllung geht zur Neige" etc.). Enorme Einsparungen beim Servicepersonal und geringere Aus-Zeiten der Geräte sind die positive Folge.

Zudem können auch relativ komplizierte Ladevorgänge durchgeführt werden, welche manuell gar nicht oder sehr mühselig möglich wären, wie z.B. Abkühlen und Laden über mehrere Tage und auch nachts. Somit hat das wertvolle Magnet-System und die teure NMR-Anlage generell deutlich geringere Ausfallzeiten zu verkraften. Durch das komplett überwachte und automatische Laden kann der Magnet auch hinsichtlich seiner Stromtragung besser ausgelastet werden. Er kann damit kompakter entwickelt werden und wird leichter und in der Fertigung kostengünstiger.

Eine Kontrolleinheit steuert die verschiedenen Komponenten mittels eines Algorithmus unter Berücksichtigung diverser Messwerte und Parameter. Die Kontrolleinheit umfasst auch das automatische Strombeladungsprogramm, z.B. auf einem FPGA, welches zum Ladeprozess abgerufen wird.

Ein wichtiger Teilaspekt ist das "Push-Button" Prinzip, wonach die Magneten einfach per Knopfdruck geladen werden können.

Ein weiteres Ziel der vorliegenden Erfindung kann es aber sogar sein, ein komplett autarkes Magnetsystem bereitzustellen, welches auf Knopfdruck sowohl automatisch und selbständig auf eine ausreichend tiefe kryogene Temperatur abkühlt sowie anschließend durch autonomes elektrisches Beladen des MR-Magnetspulensystems ein NMR-Magnetfeld gewünschter Feldstärke erzeugt, ohne dass für den ganzen komplexen Vorgang technisches Überwachungs- und Bedienungspersonal vor Ort sein muss.

Dieses Ziel eines automatischen Herunterkühlens und elektrischen Aufladens einer supraleitenden Magnetspule kann nun durch eine Kombination der Merkmalskomplexe der vorliegenden Erfindung mit den in Referenz [7] offenbarten Vorgehensweisen erreicht werden.

Damit ergibt sich ein neuartiges Betriebsverfahren, welches mit Hilfe einer einfachen Kontrolleinheit -quasi auf Knopfdruck- das supraleitfähige Magnetsystem selbständig abkühlt und ab einer geeigneter kryogenen Temperatur die Magnetspulen auch automatisch mit elektrischem Strom auflädt.

Das System kann entsprechend auf Störungen von außen reagieren, gegebenenfalls Fehlermeldungen erzeugen und diese an ein -nicht notwendig vor Ort stationiertes- Überwachungszentrum versendet. Das Magnetspulensystem wird auf diese Weise weitestgehend autark und autonom und ist nicht nur ohne weiteres Zutun von technischem Personal automatisch betreibbar, sondern kann sogar flexibel und unaufwändig vom Endkunden selbst auf Betriebstemperatur und Feld gebracht werden.

Enorme Einsparungen beim Service, insbesondere hinsichtlich des Einsatzes von Fachpersonal beim Betreiber der MR-Apparatur, und geringere Ausfallzeiten der Geräte sind die Folge. Das ganze System wird insgesamt kompakter, leichter und in jeder Hinsicht kostengünstiger.

Eine MR-Apparatur zur Durchführung des oben beschriebenen erfindungsgemäßen Verfahrens ist in Anspruch 12 definiert und ist ausgestattet mit einem in einem Vakuumbehälter angeordneten, im MR-Messbetrieb trockenen, d.h. Kryogen-freien, supraleitfähigen MR-Magnetspulensystem sowie mit einem Kryostaten zum Kühlen des MR-Magnetspulensystems, welcher ein Halsrohr umfasst, das durch einen Außenmantel des Vakuumbehälters hindurch zum MR-Magnetspulensystem führt, wobei ein Kühlarm eines Kaltkopfes zumindest teilweise im Halsrohr angeordnet ist, wobei um den Kühlarm herum ein abgeschlossener Hohlraum ausgebildet ist, der gegenüber dem zu kühlenden MR-Magnetspulensystem fluiddicht abgedichtet und im Normalbetrieb der MR-Apparatur zumindest teilweise mit einem kryogenen Fluid gefüllt ist. Hinsichtlich einer solchen MR-Apparatur wird die noch weiter gefasste Erfindungsaufgabe eines gleichermaßen autonomen Abkühlens und elektrischen Aufladens mit körperlichen Merkmalskomplexen dadurch gelöst, dass außerhalb des Vakuumbehälters eine Vakuumpumpe sowie ein erstes Absperrventil in einer von der Vakuumpumpe in den Vakuumbehälter führenden Vakuumleitung angeordnet sind, dass ein Temperatursensor zur Messung einer aktuellen Temperatur $T_{coil}$ am MR-Magnetspulensystem sowie ein erster Drucksensor zur Messung eines aktuellen Drucks $P_{ist}$ im Vakuumbehälter vorhanden sind, und dass eine Kontrolleinheit zum Erfassen und Vergleichen der aktuellen Temperatur $T_{coil}$ am MR-Magnetspulensystem mit vorgegebenen Temperatursollwerten, zum Erfassen und Vergleichen des aktuellen Drucks $P_{ist}$ im Vakuumbehälter mit vorgegebenen Drucksollwerten sowie zur Ansteuerung eines ersten Absperrventils, der Vakuumpumpe, des Kaltkopfes und des Lade-Netzgeräts konfiguriert ist.

Ein zur Durchführung des oben beschriebenen erfindungsgemäßen Auflade-Verfahrens geeigneter Kryostat in Verbindung mit dem in Referenz [7] offenbarten Abkühl-Verfahren trägt zur Lösung der erweiterten Erfindungsaufgabe dadurch bei, dass eine Fluidleitung vorgesehen ist, die einenends in einen den Kühlarm des Kaltkopfs umgebenden Hohlraum, anderenends in ein mit einem kryogenen Fluid gefüllten Druckbehälter außerhalb des Halsrohrs mündet, und dass ein zweiter Drucksensor zur Messung des aktuellen Drucks $P_{HR}$ im Hohlraum vorhanden ist.

Schließlich erfordert eine Vorrichtung zur Durchführung eines solchen neuartigen Verfahrens eine elektronische Kontrolleinheit gemäss Anspruch 13, die zum Erfassen und Vergleichen einer aktuellen Temperatur $T_{coil}$ am MR-Magnetspulensystem mit vorgegebenen Temperatursollwerten, sowie zum Erfassen und Vergleichen eines aktuellen Drucks $P_{ist}$ im Vakuumbehälter mit vorgegebenen Drucksollwerten konfiguriert ist, und welche die verschiedenen Komponenten mittels eines Algorithmus unter Berücksichtigung diverser Messwerte und Parameter steuert. Die Kontrolleinheit ist wesentlich für die Funktionalität des autarken Kühlens, denn es bedarf einer kontinuierlichen Erfassung der Temperatur- und Druckwerte und einer sinnvollen Ansteuerung von Vakuumpumpe und Kühlung in Abhängigkeit der vorliegenden Messwerte mittels des dafür eingerichteten Algorithmus.

Die Kontrolleinheit trägt zur Lösung der Erfindungsaufgabe dadurch bei, dass sie eine Messeinheit aufweist, an welche ein Temperatursensor zur Messung der aktuellen Temperatur $T_{coil}$ am MR-Magnetspulensystem sowie ein Drucksensor zur Messung des aktuellen Drucks $P_{ist}$ im Vakuumbehälter angeschlossen sind. Vorzugsweise umfasst die Messeinheit auch einen Temperatursensor zur Messung der aktuellen Temperatur $T_{shield}$ am Strahlungsschild des Kryostaten. Außerdem umfasst die Kontrolleinheit eine Ansteuereinheit zum Öffnen und Schließen des ersten Absperrventils, zur Aktivierung und Deaktivierung der Vakuumpumpe sowie zur Aktivierung und Deaktivierung des Kaltkopfes und enthält eine Prozessoreinheit, die als Schnittstelle zwischen der Messeinheit und der Ansteuereinheit angeordnet ist zum Abgleich der erfassten Sensorparameter mit den Sollparametern und der Verarbeitung der Daten zur Ansteuerung von Kaltkopf, Vakuumpumpe, Absperrventil und Lade-Netzgerät.

Besondere Vorteile des erfindungsgemäßen, autonomen Kühl- und Ladeverfahrens:

1. Automatisierte Abkühl- und Ladeprozedur bei erstmaliger Inbetriebnahme einer MR-Apparatur mit supraleitfähigem Magnetspulensystem
2. Automatisierte Abkühl- und Ladeprozedur nach Überhitzung des Magnetspulensystems nach einem Ausfall der Kühleinheit oder durch einen Quench (="Auto Cooling")
3. Permanente Temperatur- und Druck-Messungen ermöglichen

a) automatisierte Überprüfung der aktuellen Temperatur $T_{coil}$ am MR-Magnetspulensystem und $T_{shield}$ am Strahlungsschild;
b) automatisierte Überprüfung des aktuellen Drucks $P_{ist}$ im Vakuumbehälter.

Varianten, bevorzugte Ausführungsformen und Weiterbildungen der Erfindung

Von ganz besonderem Vorteil ist eine bevorzugte Variante des erfindungsgemäßen Verfahrens, bei welcher folgende Zwischenschritte zwischen Schritt (d) und Schritt (e) durchgeführt werden:

(d1) sobald $I_{coil} = I1_{target}$: Stoppen des Kühlvorgangs des supraleitfähigen MR-Magnetspulensystems (dadurch erwärmt sich das Magnetspulensystem langsam);
(d2) Messen der aktuellen Temperatur $T_{coil}$ am MR-Magnetspulensystem und Vergleichen von $T_{coil}$ mit einem vorgebbaren zweiten Temperatursollwert $T2_{tov} < T1c$, bei welchem die supraleitende Stromtragfähigkeit des MR-Magnetspulensystems auf einen vorgebbaren niedrigeren Wert herabgesetzt wird, ohne dass die Supraleitung im Magnetspulensystem vollständig zusammenbricht;
(d3) sobald $T_{coil} = T2_{tov}$: Wiederanfahren des Kühlvorgangs des supraleitfähigen MR-Magnetspulensystems.

In diesem Zustand wird der Kompressor deaktiviert und gewartet, bis die Spulentemperatur $T_{coil}$ die

gesetzten Temperaturgrenzwerte von $T2_{tov}$ , also der Temperatur für das thermische Überschwingen (="thermal overshoot") erreicht hat. Dies dauert je nach Magnetsystem bis zu einer Stunde. Sobald $T2_{tov}$ erreicht ist, wird der Kompressor wieder aktiviert und eine fixe Zeit, z.B. von etwa 20s gewartet, um dem Kompressor Zeit zum Starten zu geben. Danach wird in einen Betriebszustand gewechselt, bei welchem das Kühlsystem aktiviert ist, sodass ggf. verdampftes Helium aus dem Halsrohr rückverflüssigt werden kann. Dies passiert ebenfalls bei einer Sensor-Fehlfunktion. Sollte der Magnet in diesem Zustand quenchen, steigt die Temperatur $T_{coil}$ über einen kritischen Wert und der Ladeprozess muss re-initiiert werden, indem die Temperatur der Spule im Kryostaten wieder auf $T_{coil} \leq T1_{ramp}$ gebracht wird.

Durch einen thermisches Überschwingen wird die Stromverteilung in den supraleitenden Filamenten gleichverteilt und optimiert. Damit wird in wesentlich schnellerer Zeit die Driftspezifikation erreicht. MR spezifische Messungen können somit unmittelbar nach dem thermischen Überschwingen begonnen werden. Bei herkömmlichen Magnetsystem ohne thermisches Überschwingen kann dies Tag bis zu Wochen dauern.

Das thermische Überschwingen ist vorzugsweise Bestandteil des automatischen Ladeprozesses und verkürzt die Zeit für das Erreichen der "Driftspec", d.h. dass die Ströme in der Supraleiterspule so weit stabilisiert sind, dass sich das Magnetfeld nicht mehr oder nur noch geringfügig ändert. Es findet also abschließend, nach jedem Ladevorgang der thermische Overshoot statt. Dieser dient dazu, durch die Temperaturerhöhung eine schnellere, gleichmäßige Stromverteilung in den supraleitenden Filamenten zu erzwingen, womit der Magnet schneller seine Driftspec erreicht (keine Umkopplungen mehr in den Filamenten).

In herkömmlichen Bad-gekühlten Magnetsystemen wird das Überschwingen durch leichtes Überladen über die Sollstromstärke und anschließendes Zurückfahren auf die Sollstromstärke erreicht. Überraschenderweise hat das rein thermische Überschwingen, ohne die Stromstärke in der Spule zu verändern, denselben Effekt, nämlich zeitnah auf die Driftspecs zu kommen.

Ebenfalls überraschenderweise verkürzt sich diese Zeit derart drastisch, dass ein 7T Magnet nach Abklingen des thermischen Overshoots bereits nach einem Tag in den Specs ist. Ohne thermischen Overshoot dauert es hier etwa vier Tage.

Bei einem 9T Magneten dauert es aufgrund der Hochfilament-Drähte etwas länger und auch der thermische Overshoot verlängert sich, da man öfter und mithin länger in einem erhöhten Temperaturbereich verweilt. Der Magnet sollte nach dem Abklingen des thermischen Overshoots nach ca. 2-3 Tagen in den Specs sein. Ohne thermischen Overshoot würde es hier bis zu einer Woche und mehr dauern.

Ein thermischer Overshoot bei Bad-gekühlten Magneten dauert extrem lang, da man die ganze Helium-Menge mit aufwärmen muss. Er ist nur in einem eingeschränkten Temperaturbereich möglich.

Vorteilhaft können auch Varianten des erfindungsgemäßen Verfahrens sein, bei denen die Schritte (d1) bis (d3) nach dem Erreichen des Kriteriums $T_{coil} = T2_{tov}$ mehrmals wiederholt werden. Mehrfaches Wiederholen beschleunigt diesen den oben beschriebenen Vorgang. Dies verkürzt zusätzlich die Zeit bis zum Erreichen der Driftspecs. Mit jedem thermischen Overshoot kann dieses Abklingverhalten zusätzlich verkürzt werden und man erreicht die typischen Driftwerte je nach Magnetsystem in wenigen Stunden.

Bei weiteren wichtigen Varianten des erfindungsgemäßen Verfahrens wird falls $T_{coil} > T1_{ramp}$ in Schritt (b2) das Aufladen des MR-Magnetspulensystems mit elektrischem Strom unterbrochen und der Kühlvorgang weitergeführt wird bis $T_{coil} \leq T1_{ramp}$ ; danach erfolgt die Wiederaufnahme in Schritt (b1).

Durch das "Parkieren" wird die thermische Belastung des Ladevorgangs reduziert. Man erhöht damit wieder die Temperatur Marge gegenüber $T_c$.

Das Stoppen/Unterbrechen des Ladeprozesses ist im Normalfall ein transienter Zustand und dient der Sicherheit vor einem Quench des Supraleiters, denn beim Ladeprozess entsteht Wärme, die ggf. nicht schnell genug abgeführt werden kann.

Bei der Unterbrechung wird zuerst der Zielstrom auf den aktuell gemessenen Strom sowie die Spannung auf 0V gesetzt, ebenso werden der Hauptheizer und der Screening Heizer deaktiviert, sodass der Magnet kurzgeschlossen ist. Danach wird der aktuelle Strom notiert und der Hauptstrom auf 0A gesetzt und somit aus den Stromkabeln gefahren. Sobald der Strom auf 0 A ist, bleibt nur die Kühlung aktiv.

Besonders bevorzugt ist auch eine Klasse von Ausführungsformen des erfindungsgemäßen Verfahrens, die sich dadurch auszeichnen, dass um den Kühlarm herum ein abgeschlossener Hohlraum ausgebildet ist, der gegenüber dem zu kühlenden MR-Magnetspulensystem fluiddicht abgedichtet und im Normalbetrieb der MR-Apparatur zumindest teilweise mit flüssigem Helium gefüllt ist, dass das Halsrohr über ein erstes Ventil V1 mit einer Heliumgaszufuhr verbunden ist, durch welches einerseits Heliumgas eingeleitet werden kann, um am Kühlarm verflüssigt zu werden, und anderseits, dass das Helium im Halsrohr während der Schritte (c) und (d), abgepumpt wird mit folgenden Schritten

(c0') Messen des aktuell im MR-Magnetspulensystem fließenden elektrischen Stroms $I_{coil}$ und Vergleichen von $I_{coil}$ mit einem vorgebbaren zweiten Stromsollwert $I2_{pump} < I1_{target}$, ab welchem das Helium im Halsrohr abgepumpt werden soll; und

(c0") sobald $I_{coii} \geq I2_{pump}$: Aktivieren einer außerhalb des Vakuumbehälters angeordneten Vakuumpumpe, Öffnen des ersten Absperrventils in einer von der Vakuumpumpe in das Halsrohr führenden Abpumpleitung, um mit der Vakuumpumpe Heliumgas aus dem Halsrohr zu pumpen.

Durch das Abpumpen des Heliums aus dem Halsrohr können noch tiefere Temperaturen im Kryostaten erzielt werden. Das schützt zum einen die Supraleiter vor dem Erwärmen beim Laden und es beschleunigt somit den Ladeprozess an sich, weil es weniger Unterbrechungen gibt.

Man erzeugt damit eine zusätzliche Kühlleistung, die es ermöglicht tiefere Temperaturen zu erreichen, als mit dem Kaltkopf alleine möglich wäre. Dadurch wird im besonders kritischen Bereich, kurz vor Erreichen des Zielfelds, die Temperatur Marge gegenüber $T_c$ nochmals deutlich vergrößert. Dieses Verfahren ermöglicht das zuverlässige Erreichen von besonders kritischen, nahe an $T_c$ ausgelegte, Feldstärken. Dadurch können kleinere, kompaktere Magnetsysteme gebaut werden.

Vorteilhaft sind Weiterbildungen dieser Verfahrensvarianten, bei welchen die Zufuhrleitung zum Halsrohr über ein weiteres Ventil V3 mit der Vakuumpumpe verbunden ist, und dass in einem Schritt (f) Helium in das Halsrohr zugeführt und verflüssigt wird.

Da das abpumpbare Heliumvolumen auf wenig (z.B. 1,5l) flüssiges Helium begrenzt ist, kann nur für eine bestimmte Zeit gepumpt werden, danach muss neu Helium verflüssigt werden. Sobald die Pumpzeit, welche im Ladeskript definiert ist, überschritten ist, muss Helium verflüssigt werden.

Hierdurch ist es möglich, das ggf. beim Laden abgepumpte Helium wieder aufzufüllen und zu verflüssigen. Somit wird gewährleistet, dass bei einem Ausfall der Kühleinheit, immer das volle Heliumvolumen zur Abdampfung bereit steht. Dadurch kann die Zeit bis zu einem Quench, nach einem Kühlerausfall auf mehrere Stunden, verlängert werden.

Die genannten Verfahrensvarianten können alternativ oder ergänzend auch noch dadurch weitergebildet werden, dass bei Bedarf, etwa bei Ausfall des Kaltkopfes, in einem Schritt (c0‴) zwischen den Schritten (c) und (d), gegebenenfalls vor den Schritten (d1) bis (d3) mit der Vakuumpumpe das flüssige Helium im Halsrohr abgepumpt wird, um das MR-Magnetspulensystem zu kühlen.

Hierdurch ist es möglich Magnetsysteme zu bauen, die eine Auslegungstemperatur haben, die unterhalb der Verdampfungstemperatur von Helium liegt (4,2K). Dadurch können kleinere, kompaktere Magnetsysteme gebaut werden.

Dieser Verfahrensschritt dient der Absicherung vor einem Quench des Supraleiters, wenn es tatsächlich zu einem Ausfall des Kaltkopfes kommt, denn dann wird die Zeit bis zur Erwärmung auf die Sprungtemperatur verlängert.

Die Stromzufuhr in den supraleitenden Magneten während des Ladevorgangs erfolgt über sogenannte Stromstäbe, die eine guten elektrischen Leiter enthalten. Im Falle der kryogenfreien Magneten kommen Hochtemperatur Supraleiter (=HTS) zum Einsatz, da durch diese einen geringeren Wärmeeintrag in den Kryostaten verursachen, verglichen beispielsweise mit Kupfer. Die HTS Stromstäbe sind üblicherweise thermisch am Strahlungsschild angebunden, das bei einer Temperatur $T_{shield}$ unterhalb der Sprungtemperatur des HTS Leiters sein sollte, damit der HTS Leiter während des Ladeprozesses nicht quencht und dadurch zerstört wird. Daher ist die Überwachung der Strahlungsschildtemperatur notwendig.

Bevorzugte Verfahrensvarianten können auch noch dadurch weitergebildet sein, dass falls $T_{istshield} > T_{shield}$ das Aufladen des MR-Magnetspulensystems mit elektrischem Strom in Schritt (b2) unterbrochen und der Kühlvorgang weitergeführt wird bis $T_{istshield} \leq T_{shield}$, danach erfolgt die Wiederaufnahme des Verfahrens in Schritt (b1).

Hierdurch wird verhindert, dass beim Ladevorgang des Magneten die HTS Stromstäbe ihre kritische Temperatur erreichen und durchbrennen. Wenn die Strahlungsschildtemperatur in einen für den HTS-Leiter kritischen Bereich kommt, sollte das Laden unterbrochen werden, um einen HTS-Quench zu vermeiden. Durch das "Parkieren" des Ladevorgangs erfolgt ein Abkühlen der HTS Stromstäbe.

Wie bereits oben im Zusammenhang mit dem autonomen Kühl-Verfahren ausgeführt, ist eine spezielle elektronische Kontrolleinheit zur automatischen Durchführung des Verfahrensablaufs erforderlich. Dies gilt ebenso für das vorliegende erfindungsgemäße autonome Lade-Verfahren. Eine ganz besonders bevorzugte Klasse von Ausführungsformen des erfindungsgemäßen Verfahrens zeichnet sich deshalb dadurch aus, dass der autonome elektrische Ladevorgang des supraleitfähigen MR-Magnetspulensystems mittels einer elektronischen Kontrolleinheit automatisch geregelt wird, wobei die Kontrolleinheit zum Erfassen und Vergleichen der aktuellen Temperatur $T_{coil}$ am MR-Magnetspulensystem bzw. bis $T_{istshield}$ am Strahlungsschild mit vorgegebenen Temperatursollwerten, zum Erfassen und Vergleichen des aktuell im MR-Magnetspulensystem fließenden elektrischen Stroms $I_{coil}$ mit vorgegebenen Stromsollwerten sowie gegebenenfalls zur Ansteuerung von Ventilen, eines Lade-Netzgeräts, einer Vakuumpumpe und Funktionseinheiten des Kaltkopfes konfiguriert ist.

Der elektronischen Kontrolleinheit kommt im Zusammenhang mit dem Ladeprozess eine zentrale Rolle zu, denn sie umfasst das automatische Strombeladungsprogramm, welches ein für jede Magnetklasse optimiertes Ladeskript umfasst, das ein standardisiertes und sicheres Laden des Magneten gewährleistet. Somit lassen sich hochkomplexe, selbstüberwachte Ladevorgänge mit Pausen, variablen Grenzwerten, temperaturoptimiert, falls notwendig über sehr lange Zeiträume sicher und zuverlässig durchführen.

Vorteilhaft sind hier Weiterbildungen dieser Klasse von Verfahrensvarianten, bei welchen die elektronische Kontrolleinheit den autonomen elektrischen Ladevorgang des supraleitfähigen MR-Magnetspulensystems mittels eines Algorithmus unter Berücksichtigung diverser Messwerte und Parameter, wie etwa Druck, Temperatur, Ladespannung, Ladestrom, selbsttätig in Abwesenheit von Bedienungs- oder Überwachungspersonal, auch über Nacht, insbesondere über mehrere Tage hinweg, ohne zeitliche Unterbrechung komplett automatisch regelt.

Auch hierdurch lassen sich hochkomplexe, selbstüberwachte Ladevorgänge mit Pausen, variablen Grenzwerten, temperaturoptimiert, falls notwendig über sehr lange Zeiträume sicher und zuverlässig durchführen.

Diese Weiterbildungen können noch dadurch verbessert werden, dass die elektronische Kontrolleinheit während des autonomen elektrischen Ladevorgangs des supraleitfähigen MR-Magnetspulensystems selbständig kritische Zustandsänderungen und Störungen des supraleitfähigen MR-Magnetspulensystems sowie des Kryostaten zum Kühlen des MR-Magnetspulensystems, insbesondere der Temperaturen, Ströme und Druckwerte im Vakuumbehälter erkennt und darauf entweder durch Einsatz eines vorgebbaren alternativen Algorithmus zur weiteren Regelung des autonomen elektrischen Ladevorgangs und/oder durch Senden von Nachrichten oder Fehlermeldungen, beispielsweise Email-Botschaften, an Bedienungs- oder Überwachungspersonal reagiert.

Auf diese Weise kann frühzeitig eingegriffen werden, falls sich eine Problem oder gar ein Magnet-Quench andeutet. Beispielsweise können e-Mails an das Facility Management bei Kühlwasserausfall versendet werden oder etwa an den Magnetservice bei erhöhter Schildtemperatur. Dadurch wird die mögliche Downtime erheblich reduziert und MR Messunterbrechungen werden verhindert

Alternativ oder ergänzend kann die beschriebene Klasse von Verfahrensvarianten auch dadurch weitergebildet werden, dass die elektronische Kontrolleinheit Zugriff auf einen oder auch mehrere unterschiedliche Algorithmen zum autonomen elektrischen Entladen oder Teilentladen des supraleitfähigen MR-Magnetspulensystems aus einem elektrisch beladenen Zustand heraus hat, und dass der Entladevorgang mit voreinstellbaren Randbedingungen komplett automatisch durch die elektronische Kontrolleinheit geregelt wird.

Auch hierdurch lassen sich hochkomplexe, selbstüberwachte Ladevorgänge mit Pausen, variablen Grenzwerten, temperaturoptimiert, falls notwendig über sehr lange Zeiträume sicher und zuverlässig ohne Servicetechniker durchführen. Die Betriebs- und Unterhaltskosten eines Magnetsystems werden damit erheblich reduziert.

Bevorzugte Ausführungsformen des erfindungsgemäßen Verfahrens sind dadurch gekennzeichnet, dass die vorgebbaren Temperatursollwerte $T1_{ramp}$ und $T2_{tov}$ sowie die vorgebbaren Stromsollwerte $I1_{target}$ und $I2_{pump}$ aus folgenden -beispielhaften und grundsätzlich handhabbaren- Wertebereichen ausgewählt werden:

$$2K < T1_{ramp} \leq 5K,$$

vorzugsweise etwa 4,2K;

$$2K \leq T2_{tov} < 6K,$$

vorzugsweise etwa 4,2K;

$$50A < I1_{target} \leq 500A,$$

vorzugsweise etwa 250A

$$30A \leq I2_{pump} < 400A,$$

vorzugsweise etwa 350A

$$30K \leq T_{shield} < 77K,$$

vorzugsweise etwa 65K.

Weitere vorgebbare Temperatursollwerte $T1_{soll}$, $T2_{soll}$ und $T3_{soll}$ sowie ein vorgebbare Drucksollwert $P1_{soll}$ können aus folgenden Wertebereichen ausgewählt werden:

$$5K \leq T1_{soll} \leq 20K,$$

vorzugsweise etwa 8K;

$$3K \leq T2_{soll} \leq 5K,$$

vorzugsweise etwa 4,2K;

$$250K \leq T3_{soll} \leq 300K,$$

vorzugsweise etwa 280K

$$10^{-4}mbar \leq P1_{soll} \leq 10^{-1}mbar,$$

vorzugsweise etwa $10^{-3}$mbar.

Diese Werte werden verwendet, wenn das MR-Spulensystem LTS-Leiter (Niedertemperatursupraleiter) enthält, die typischerweise bei der Temperatur von flüssigem Helium, also kleiner als 4,2K betrieben werden. Das kryogene Fluid im Halsrohr ist demgemäß Helium.

$T1_{soll}$ entspricht der Temperatur, ab welcher das Vakuum im Vakuumbehälter wiederhergestellt werden muss.

$T2_{soll}$ entspricht der Betriebstemperatur des MR-Magnetspulensystems bei Verwendung von LTS-Leitern.

$T3_{soll}$ entspricht der Temperatur eines vollständig aufgewärmten Magnetspulensystems.

P1$_{soll}$ ist das minimale Vakuum in der Vakuumkammer, ab welchem man davon ausgehen kann, dass nur noch wenig Restgase vorhanden sind und daher mit der Kühlung begonnen werden kann.

In den Rahmen der vorliegenden Erfindung fällt auch die bereits oben beschriebene Magnetresonanz(="MR")-Apparatur zur Durchführung des erfindungsgemäßen Verfahrens. Diese kann bei vorteilhaften Ausführungsformen so ausgestaltet werden, dass die Vakuumpumpe mindestens 2stufig aufgebaut ist und eine Turbomolekularpumpe sowie eine Vorpumpe hierfür, vorzugsweise eine Membranpumpe, aufweist. Beide Pumpen sind vorzugsweise in Serie geschaltet. In der Regel erreichen nur diese zweistufigen Pumpen ein ausreichendes Hochvakuum.

Des Weiteren kann der -ebenfalls bereits oben beschriebene, für die erfindungsgemäße MR-Apparatur erforderliche- Kryostat zum Kühlen des MR-Magnetspulensystems dadurch weitergebildet werden, dass das mit dem Hohlraum verbundene Ende der Fluidleitung über ein zweites Absperrventil in einen Bereich der Vakuumleitung zwischen dem ersten Absperrventil und der Turbomolekularpumpe mündet, und dass das mit dem Druckbehälter verbundene Ende der Fluidleitung über ein drittes Absperrventil in einen Bereich der Vakuumleitung zwischen der Turbomolekularpumpe und ihrer Vorpumpe mündet. Die getrennten Ventile führen dazu, dass die Heliumzufuhr getrennt von den Vakuumpumpen angeordnet ist, damit die Heliumzufuhr beim Pumpen am Halsrohr nicht leergepumpt wird.

In den Rahmen der vorliegenden Erfindung fällt auch eine Kontrolleinheit zur Durchführung des erfindungsgemäßen Verfahrens, wie sie ebenfalls bereits oben beschrieben ist.

Besonders bevorzugt ist eine Klasse von Ausführungsformen der erfindungsgemäßen Kontrolleinheit, die dadurch gekennzeichnet sind, dass an die Messeinheit der zweite Drucksensor zur Messung des aktuellen Drucks P$_{HR}$ in dem den Kühlarm des Kaltkopfs umgebenden Hohlraum angeschlossen ist, und dass die Ansteuereinheit zum Öffnen und Schließen des zweiten und des dritten Absperrventils konfiguriert ist.

Wenn das Magnetspulensystem noch warm ist, dient die Messung von P$_{HR}$ zur Überwachung des Drucks beim initialen Spülen des Halsrohrs mit He. Dabei wird abwechselnd mit der Vakuumpumpe, bei Verwendung einer zweistufigen Pumpe vorzugsweise mit der Membranpumpe, das Halsrohr über V2 geleert und über V1 mit Helium befüllt, sodass möglichst wenig Fremdgase im Halsrohr vorhanden sind vor der Kühlung.

Die Messung von P$_{HR}$ dient auch dazu, nach vollzogenem Herunterkühlen zu überwachen, ob ausreichend Helium im Druckbehälter vorhanden ist, um das Befüllen des Halsrohrs mit Helium zu überwachen. Es dient auch dazu, die Manometer-Einstellung am Helium-Druckbehälter zu überprüfen während des Betriebs, damit kein Über- oder Unterdruck an der Zufuhrleitung entsteht.

In der Praxis bewähren sich Weiterbildungen dieser Ausführungsformen, bei welchen eine Verbindung vom Halsrohr zur Vakuumpumpe vorhanden ist, wobei die Kontrolleinheit die Steuerung von V2 zur Vakuumpumpe regelt. Die Vakuumpumpe dient zum einen dazu, bei zu starker Erwärmung des Kryostaten, das Halsrohr zunächst vollständig von Fremdgasen zu befreien, bevor die Kühlung beginnt. Das verhindert das An-eisen von Fremdstoffen, welches die Funktionalität des Kaltkopfs beeinträchtigen würde. Zum anderen kann die Vakuumpumpe sinnvoll dann im kalten Zustand eingesetzt werden, um bei Ausfall des Kaltkopfes die Erwärmung des Kryostaten durch Abpumpen des vorhandenen Heliums zu verzögern. Die Kontrolleinheit regelt die Ansteuerung von V2 und Vakuumpumpe in Abhängigkeit von den gemessenen Parametern.

Alternativ oder ergänzend zeichnen sich andere Weiterbildungen dadurch aus, dass eine Verbindung von einer Heliumgaszufuhr zum Halsrohr vorhanden ist, und dass die Kontrolleinheit die Steuerung der He-Zufuhr über das erste Ventil V1 regelt. Auf diese Weise kann nach Strom oder Wasserausfällen kontrolliert Helium verflüssigt werden, um das kleine Reservoir im Halsrohr wieder aufzufüllen. Dadurch wird gewährleistet, dass immer genügend flüssiges Helium in Halsrohr ist, um bei einem Kühlerausfall einige Stunden ohne Quench zu überstehen.

Ganz besonders bevorzugt sind Anwendungen der erfindungsgemäßen Verfahrensvarianten und Vorrichtungen im Bereich der Magnetresonanz, insbesondere in der NMR-Spektroskopie und bei MRI-Apparaturen.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert.

Es zeigen:

Fig. 1      eine schematische Vertikalschnitt-Darstellung einer Ausführungsform der Magnetresonanzapparatur in der 1-Ventil-Version zur Durchführung des erfindungsgemäßen Auto-Loading-Verfahrens;

Fig. 2      ein Flussdiagramm des prinzipiellen Verfahrensablaufes des erfindungsgemäßen Auto-Loading-Verfahrens mit thermischem Überschwingen ("thermal overshooting") in Form eines Algorithmus, wie er in einem entsprechenden Programm in der Kontrolleinheit ablaufen soll, und zwar vorzugsweise für Ausführungsformen in der 1-Ventil-Version wie in Fig. 1;

Fig. 3     ein schematisiertes Flussdiagramm mit den Verfahrensschritten gemäß der Ansprüche bei Ausführungsformen vorzugsweise in der 1-Ventil-Version wie in Fig. 1;

Fig. 4     eine schematische Vertikalschnitt-Darstellung einer Ausführungsform der Magnetresonanzapparatur in der 3-Ventil-Version zur Durchführung des erfindungsgemäßen Auto-Loading-Verfahrens;

Fig. 5     ein Flussdiagramm des prinzipiellen Verfahrensablaufes des erfindungsgemäßen Auto-Loading-Verfahrens mit thermischem Überschwingen in Form eines Algorithmus, wie er in einem entsprechenden Programm in der Kontrolleinheit ablaufen soll, und zwar für Ausführungsformen in der 3-Ventil-Version wie in Fig. 4;

Fig. 6     ein schematisiertes Flussdiagramm mit den Verfahrensschritten gemäß der Ansprüche in der Untervariante mit Heliumverflüssigung bei Ausführungsformen in der 3-Ventil-Version wie in Fig. 4;

Fig. 7     ein Aufbau-Schema einer Vorrichtung zum erfindungsgemäßen autonomen elektrischen Laden des supraleitfähigen MR-Magnetspulensystems einer MR-Apparatur mit schematischem Spulensystem, Lade-Netzgerät, Pumpeneinheit und Kontrolleinheit zur Steuerung des Ladevorgangs;

Fig. 8a     ein schematisches Zeitdiagramm für die Verfahrensvariante *"Ladeunterbrechung (= Parkieren) bei Erreichen einer maximal vorgegebenen Strahlungsschildtemperatur";*

Fig. 8b     ein schematisches Zeitdiagramm für die Verfahrensvariante *"Ladeunterbrechung bei Erreichen einer maximal vorgegebenen Spulentemperatur";*

Fig. 9     ein schematisches Zeitdiagramm für eine Verfahrensvariante des erfindungsgemäßen Auto-Loading-Verfahrens mit mehrfachem thermischem Überschwingen ("thermal *overshooting"*); und

Fig. 10     ein schematisches Zeitdiagramm des Driftverhaltens nach dem Laden mit und ohne thermisches Überschwingen ("thermal overshooting").

Die vorliegende Erfindung befasst sich in ihrem Kern mit einem speziell modifizierten Verfahren zum Betrieb einer **Magnetresonanz-Apparatur 10** (="MR-Apparatur"), insbesondere mit dem autonomen Herunterkühlen einer supraleitfähigen Magnetanordnung.

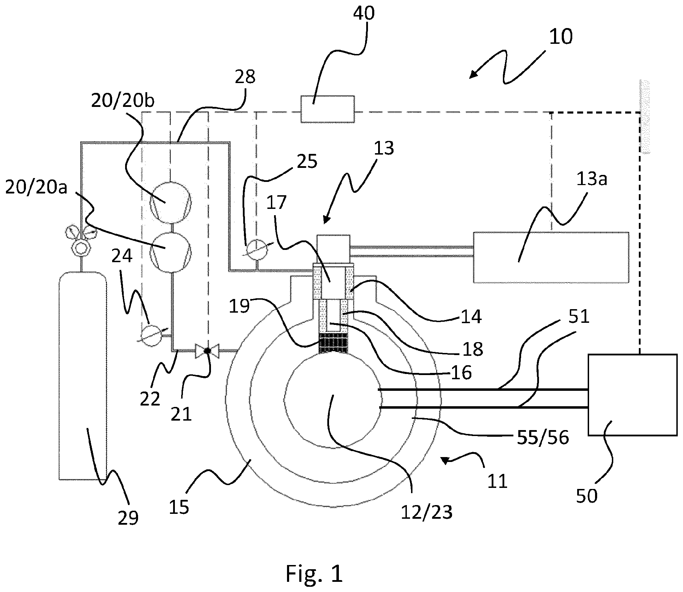

**Fig. 1** zeigt schematisch eine besonders einfache Ausführungsform der Magnetresonanz-Apparatur 10 mit nur *einem Ventil* zur Durchführung des erfindungsgemäßen Auto-Cooling-Verfahrens.

Die MR-Apparatur 10 umfasst einen **Vakuumbehälter 11** mit einem supraleitfähigen **MR-Magnetspulensystem 12**. Im MR-Messbetrieb ist dieses MR-Magnetspulensystem 12 trocken, das heißt Kryogen-frei. Die Kühlung erfolgt über einen **Kryostaten 13,** der mit einen **Kompressor 13a** verbunden ist. Der Kryostat 13 beinhaltet ein **Halsrohr 14,** welches durch einen **Außenmantel 15** des Vakuumbehälters 11 hindurch zum MR-Magnetspulensystem 12 geführt wird. Im Halsrohr 14 des Kryostaten 13 ist ein **Kühlarm 16** eines **Kaltkopfes 17** angeordnet. Ein **Hohlraum 18** ist um den Kühlarm 16 herum ausgebildet. Der Hohlraum 18 ist gegenüber dem zu kühlenden MR-Magnetspulensystem 12 fluiddicht abgedichtet. Im hier gezeigten Betriebszustand ist der Hohlraum 18 teilweise mit einem **kryogenen Fluid 19** (z. B. flüssiges Helium), sowie gasförmigem Helium gefüllt.

Außerhalb des Vakuumbehälter 11 ist eine **Vakuumpumpe 20** angeordnet, die hier als 2stufige Vakuumpumpe 20 ausgebildet ist. Vakuumpumpe 20 umfasst dabei eine **Turbomolekularpumpe 20a** mit einer **Vorpumpe 20b** (z. B. einer Membranpumpe). Die Vakuumpumpe 20 ist mit einem ersten **Absperrventil 21** (Absperrventil V3) über eine **Vakuumleitung 22** mit dem Vakuumbehälter 11 verbunden.

Am MR-Magnetspulensystem 12 ist ein **Temperatursensor 23** zur Messung einer aktuellen Temperatur $T_{coil}$ am MR-Magnetspulensystem 12 vorhanden. Ein **erster Drucksensor 24,** der über die Vakuumleitung 22 mit dem Vakuumbehälter 11 verbunden ist, misst einen aktuellen Druck $P_{ist}$ im Vakuumbehälter 11. Eine **Kontrolleinheit 40** erfasst und vergleicht die aktuelle Temperatur $T_{coil}$ am MR-Magnetspulensystem 12 mit vorgegeben Temperatursollwerten. Weiterhin erfasst und vergleicht die Kontrolleinheit 40 den aktuellen Druck $P_{ist}$ im Vakuumbehälter 11 mit vorgegebenen Drucksollwerten. Die Kontrolleinheit 40 ist weiterhin so konfiguriert, dass sie das erste Absperrventil 21, die Vakuumpumpe 20 und den Kompressor 13a des Kaltkopfes 17 ansteuern kann.

Für das erfindungsgemäße Verfahren zum autonomen elektrischen Laden des supraleitfähigen MR-Magnetspulensystems 12 wird nach der Initiierung eines geeigneten Kühlvorgangs ein automatisches Strombeladungsprogramms initiiert. Der Ladestrom wird dabei dem MR-Magnetspulensystem 12 von einem **Lade-Netzgerät 50** über **Stromstäbe 51** zugeführt.

In der Figur ist auch ein **Strahlungsschild 55** gezeigt, das gegebenenfalls mit einem (hier nicht eigens dargestellten) **Temperatursensor 56** ausgestattet ist. Die HTS Stromstäbe 51 sind thermisch mit dem Strahlungsschild 55 verbunden, sodass gewährleistet ist, dass diese HTS-Teile unter die Sprungtemperatur gekühlt werden.

Die Kontrolleinheit 40 beinhaltet eine Messeinheit, eine Ansteuereinheit und eine Prozessoreinheit. An die Messeinheit sind die Temperatursensoren 23 und 56 angeschlossen, mit denen die aktuelle Temperatur $T_{coil}$ und $T_{istshield}$ am MR-Magnetspulensystem 12 bzw. am Strahlungsschild 55 gemessen wird. Weiterhin ist an die Messeinheit der Drucksensor 24 angeschlossen, mit dem der aktuelle Druck $P_{ist}$ im Vakuumbehälter 11 gemessen wird. Die Ansteuereinheit ist mit dem ersten Absperrventil 21 verbunden, welches die Ansteuereinheit öffnen und schließen kann. Weiterhin ist die Ansteuereinheit mit der Vakuumpumpe 20 und dem Kaltkopf 17 (beziehungsweise dem Kompressor 13a) verbunden, welche die Ansteuereinheit aktivieren und deaktivieren kann. Die Prozessoreinheit ist zwischen der Messeinheit und der Ansteuereinheit angeordnet. Die Prozessoreinheit gleicht die erfassten Parameter des Temperatursensors 23 und des Drucksensors 24 mit den Sollparametern ab. Diese Daten werden von der Prozessoreinheit verarbeitet und zur Ansteuerung des Kaltkopfs 17, der Vakuumpumpe 20, des Absperrventils 21 und insbesondere das Lade-Netzgerät 50 genutzt.

Über einen **zweiten Drucksensor 25,** welcher an einer **Verbindung 28** angeschlossen ist, die von einer **Heliumzufuhr 29** in den Hohlraum 18 des Kryostaten 13 führt, kann der aktuelle Druck $P_{HR}$ in Hohlraum 18 gemessen werden. Der zweite Drucksensor 25 ist ebenfalls mit der Messeinheit der Prozessoreinheit verbunden.

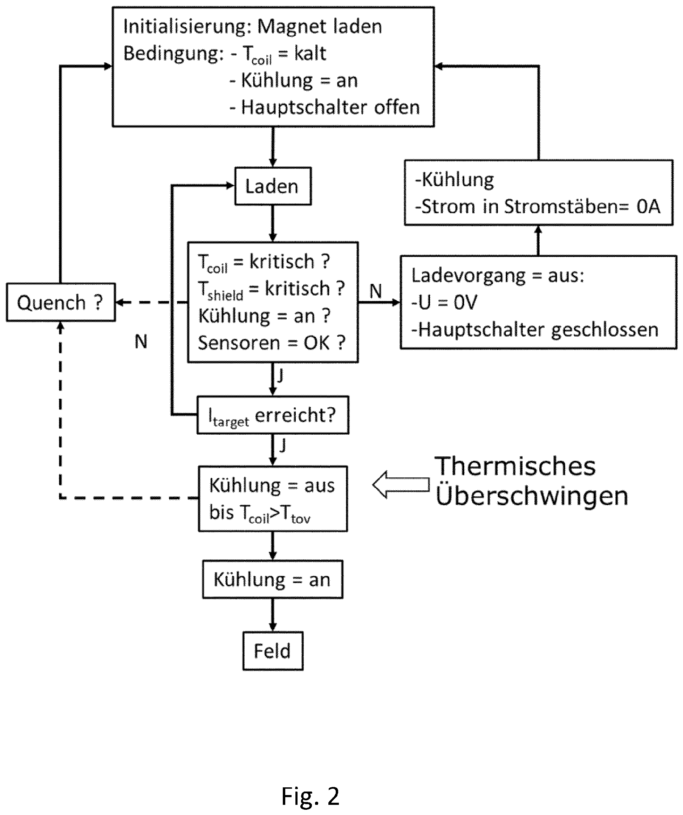

Der prinzipielle Ablauf des erfindungsgemäßen Ladeverfahrens für Ausführungsformen mit thermischem Überschwingen sowie mit nur einem Ventil ist in **Fig. 2** als Flussdiagramm dargestellt.

Ausführungsbeispiel:

Der Ablauf des erfindungsgemäßen Ladeverfahrens kann bei der 1-Ventil-Variante folgende Schritte umfassen:
Nachdem der Kühlprozess (a1) des Magneten durchlaufen und die Kühlung immer noch an ist, kann der Ladeprozess initiiert werden durch Starten des Strombeladungsprogramms (a2), das auch ein Nicht-Fachmann durch einfaches Betätigen eines entsprechenden Schalters starten kann. Das Programm durchläuft das Verfahren, indem zunächst (b1) die aktuelle Temperatur $T_{coil}$ und ggf. $T_{istshield}$ gemessen wird. Wenn die Temperaturen den Zielwert erreicht haben, ab welchem das MR-Magnetspulensystem 12 und die HTS Stromstäbe supraleitend sind und geladen werden kann, wird in Schritt (b2) der Ladestrom in das MR-Magnetspulensystem 12 zugeführt und das MR-Magnetspulensystems 12 mit elektrischem Strom geladen.

Während des Ladens wird der Zielstrom der Reihe nach stufenweise gemäß eines auf den Magneten angepassten Ladeplans eingestellt. Ist der gemessene Strom in der Nähe des jeweiligen Sollstroms, wird die nächste Stufe eingestellt. Die Ladespannung wird abhängig vom gemessenen Strom gemäß Ladeplan eingestellt. Am Ende wird der Zielstrom $I1_{target}$ erreicht. Sobald $I1_{target}$ erreicht ist, stabilisiert das Lade-Netzteil 50 automatisch den $I_{1target}$, indem es die Ladespannung auf 0V absenkt (Wechsel von Spannungs- auf Stromregelung).

Beim Laden werden permanent die Temperaturen $T_{coil}$ und $T_{istshield}$ überprüft und auch das Funktionieren der Kühlung und der notwendigen Überwachungssensoren. Sobald eine Fehlermeldung in der Kontrolleinheit 40 eingeht, wird der Ladevorgang unterbrochen und ein Wechsel zum "Parking" eingeleitet. Im Zustand "Parking" wird zuerst der Zielstrom auf den aktuell gemessenen Strom sowie die Spannung auf 0V gesetzt, ebenso werden der Hauptheizer 52" und der Screening Heizer 53" deaktiviert. Der Strom wird aus den Stromstäben 51 gefahren und es wird weiter gekühlt, bis die Solltemperaturen wieder erreicht sind, dann geht es weiter mit dem Schritt (b1).

Weiterhin wird während des Ladens in einem Schritt (c) der aktuell im MR-Magnetspulensystem 12 fließenden elektrischen Stroms $I_{coil}$ gemessen und verglichen mit einem vorgebbaren ersten Stromsollwert $I1target$, bei welchem das MR-Magnetspulensystem 12 eine gewünschte Magnetfeldstärke erzeugt. Optional können in einem Schritt (d) die Schritte (b1), (b2) und (c) so lange wiederholt werden, bis $I_{coil} = I_{1target}$. Wenn dieser Wert erreicht ist, erfolgt das thermische Überschwingen in den Schritten (d1) durch Stoppen der Kühlung und (d2) Überwachen der Temperatur. Sobald $T_{coil} = T2_{tov}$ erreicht ist, wird die Kühlung wieder angefahren (d3). Anschließend ist der Magnet auf Spec und das Strombeladungsprogramm wird in Schritt (e) beendet.

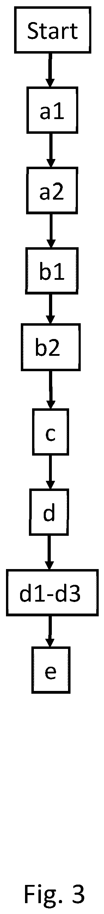

In **Fig. 3** ist ein schematisiertes Flussdiagramm des autonomen Ladeverfahrens mit den Verfahrensschritten gemäß der Ansprüche für Ausführungsformen mit nur einem Ventil dargestellt.

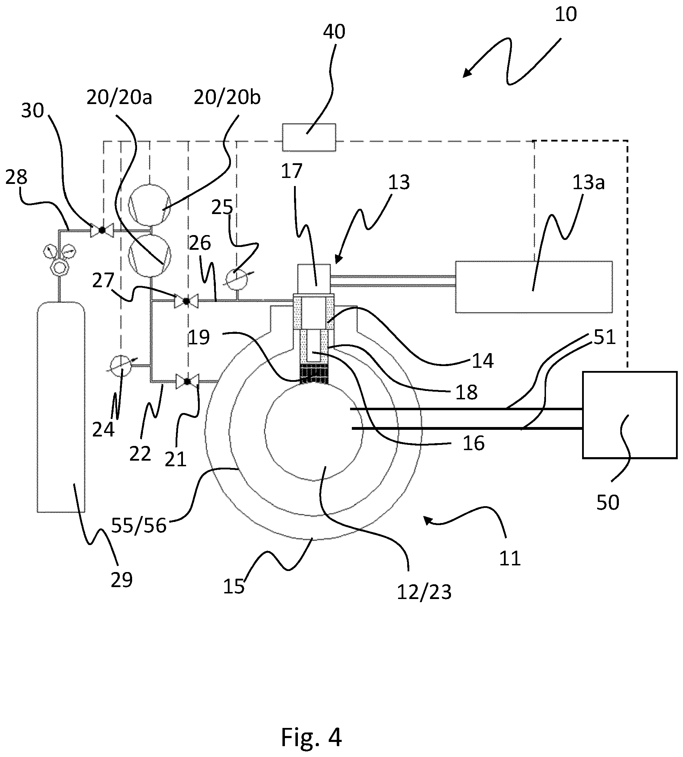

**Fig. 4** zeigt schematisch eine besonders einfache Ausführungsform einer Magnetresonanzapparatur 10 (MR-Apparatur) mit *drei Ventilen* zur Durchführung des erfindungsgemäßen Auto-Cooling-Verfahrens.

Die MR-Apparatur 10 umfasst den Vakuumbehälter 11 mit dem supraleitfähigen MR-Magnetspulensystem 12. Im MR-Messbetrieb ist dieses MR-Magnetspulensystem 12 trocken, das heißt Kryogen-frei. Die Kühlung erfolgt über einenden Kryostaten 13, der mit dem Kompressor 13a verbunden ist. Der Kryostat 13 beinhaltet das Halsrohr 14, welches durch den Außenmantel 15 des Vakuumbehälters 11 hindurch zum MR-Magnetspulensystem 12 geführt wird. Im Halsrohr 14 des Kryostaten 13 ist der Kühlarm 16 des Kaltkopfs 17 angeordnet. Der Hohlraum 18 ist um den Kühlarm 16 herum ausgebildet. Der Hohlraum 18 ist gegenüber dem zu kühlenden MR-Magnetspulensystem 12 fluiddicht abgedichtet. Im hier gezeigten Betriebszustand ist der Hohlraum 18 teilweise mit kryogenem Fluid 19 (z. B. flüssiges Helium), sowie gasförmigem Helium gefüllt.

Außerhalb des Vakuumbehälter 11 ist die Vakuumpumpe 20 angeordnet, die hier als 2stufige Vakuumpumpe 20 ausgebildet ist. Vakuumpumpe 20 umfasst dabei die Turbomolekularpumpe 20a mit der Vorpumpe 20b (z. B. einer Membranpumpe). Die Vakuumpumpe 20 ist mit dem ersten Absperrventil 21 (Absperrventil V3) über die Vakuumleitung 22 mit dem Vakuumbehälter 11 verbunden. Weiterhin ist die Vakuumpumpe 20 mit einem zweiten **Absperrventil 27** (Absperrventil V2) über eine **Verbindung 26** mit dem Halsrohr 14 verbunden.

Am MR-Magnetspulensystem 12 ist der Temperatursensor 23 zur Messung einer aktuellen Temperatur $T_{coil}$ am MR-Magnetspulensystem 12 vorhanden.

Der erste Drucksensor 24, der über die Vakuumleitung 22 mit dem Vakuumbehälter 11 verbunden ist, misst einen aktuellen Druck $P_{ist}$ im Vakuumbehälter 11. Der zweite Drucksensor 25, der über die Verbindung 26 mit dem Halsrohr 14 verbunden ist, misst einen aktuellen Druck $P_{HR}$ im Halsrohr. Die Kontrolleinheit 40 (hier nicht gezeigt) erfasst und vergleicht die aktuelle Temperatur $T_{coil}$ am MR-Magnetspulensystem 12 mit vorgegeben Temperatursollwerten. Weiterhin erfasst und vergleicht die Kontrolleinheit 40 den aktuellen Druck $P_{ist}$ im Vakuumbehälter 11 mit vorgegebene Drucksollwerten. Die Kontrolleinheit 40 ist weiterhin so konfiguriert, dass sie das erste Absperrventil 21, die Vakuumpumpe 20 und den Kompressor 13a des Kaltkopfes 17 ansteuern kann.

Die Kontrolleinheit 40 beinhaltet die Messeinheit, die Ansteuereinheit und die Prozessoreinheit. An die Messeinheit ist der Temperatursensor 23 angeschlossen, mit dem die aktuelle Temperatur $T_{coil}$ am MR-Magnetspulensystem 12 gemessen wird. Weiterhin ist an die Messeinheit der erste Drucksensor 24 angeschlossen, mit dem der aktuelle Druck $P_{ist}$ im Vakuumbehälter 11 gemessen wird. Ebenso ist der zweite Drucksensor 25 an die Messeinheit angeschossen, mit der der aktuelle Druck $P_{HR}$ im Halsrohr 14 gemessen wird. Die Ansteuereinheit ist mit dem ersten Absperrventil 21, dem zweiten Absperrventil 27 und einem dritten **Absperrventil 30** (Absperrventil V1) verbunden, welche die Ansteuereinheit öffnen und schließen kann.

Absperrventil 30 ist in Verbindung 28 integriert, die die Heliumzufuhr 29 und das Halsrohr 14 verbindet. Weiterhin ist die Ansteuereinheit mit der Vakuumpumpe 20 und über den Kompressor 13a mit dem Kaltkopf 17 verbunden, welche die Ansteuereinheit aktivieren und deaktivieren kann. Die Prozessoreinheit ist zwischen der Messeinheit und der Ansteuereinheit angeordnet. Die Prozessoreinheit gleicht die erfassten Parameter des Temperatursensors 23, des Drucksensors 24 und des Drucksensors 25 mit den Sollparametern ab. Diese Daten werden von der Prozessoreinheit verarbeitet und zur Ansteuerung des Kaltkopfs 17, der Vakuumpumpe 20, der Absperrventile 21, 27, 30 und des Lade-Netzgeräts 50 genutzt.

Auch in dieser Ausführungsform wird der Ladestrom wird dem MR-Magnetspulensystem 12 von einem Lade-Netzgerät 50 über Stromstäbe 51 zugeführt. Außerdem ist auch hier ein Strahlungsschild 55 gezeigt, das gegebenenfalls mit einem (wiederum hier nicht eigens dargestellten) Temperatursensor ausgestattet ist.

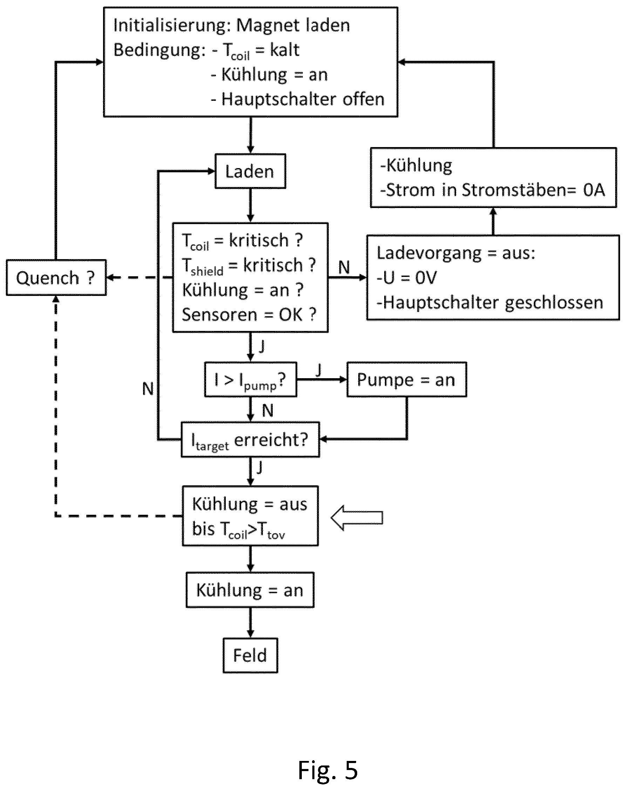

Der prinzipielle Ablauf des erfindungsgemäßen Ladeverfahrens für Ausführungsformen mit drei Ventilen ist in **Fig. 5** als Flussdiagramm dargestellt.

Ausführungsbeispiel:

Der Ablauf des erfindungsgemäßen Ladeverfahrens kann bei der 3-Ventil-Variante folgende Schritte umfassen:
Nachdem der Kühlprozess (a1) des Magneten durchlaufen und die Kühlung an ist, kann der Ladeprozess initiiert werden durch Starten des Strombeladungsprogramms (a2), das wiederum auch ein Nicht-Fachmann durch einfaches Betätigen eines Schalters starten kann. Das Programm durchläuft das Verfahren, indem zunächst (b1) die aktuelle Temperatur $T_{coil}$ und ggf. $T_{istshield}$ gemessen wird. Wenn die Temperaturen den Zielwert erreicht haben, ab welchem das MR-Magnetspulensystem 12 und die HTS Stromstäbe supraleitend sind und geladen werden kann, wird in Schritt (b2) der Ladestrom in das MR-Magnetspulensystem 12 zugeführt und das MR-Magnetspulensystems 12 mit elektrischem Strom geladen.

Während des Ladens wird der Zielstrom der Reihe nach stufenweise gemäß eines auf den Magneten angepassten Ladeplans eingestellt. Ist der gemessene Strom in der Nähe des jeweiligen Sollstroms, wird die nächste Stufe eingestellt. Die Ladespannung wird abhängig vom gemessenen Strom gemäß Ladeplan eingestellt. Am Ende wird der Zielstrom $I1_{target}$ erreicht. Sobald $I1_{target}$ erreicht ist, stabilisiert das Lade-Netzteil automatisch den $I_{1target}$, indem es die Ladespannung auf 0V absenkt (Wechsel von Spannungs- auf Stromregelung).

Beim Laden werden permanent die Temperaturen $T_{coil}$ und $T_{istshield}$ überprüft und auch das Funktionieren der Kühlung und der notwendigen Überwachungssensoren. Sobald eine Fehlermeldung in der Kontrolleinheit 40 eingeht, wird der Ladevorgang unterbrochen und ein Wechsel zum "Parking" eingeleitet. Im Zustand "Parking" wird zuerst der Zielstrom auf den aktuell gemessenen Strom sowie die Spannung auf 0V gesetzt, ebenso werden der Hauptheizer 52" und der Screening Heizer 53" deaktiviert. Der Strom wird aus den Stromstäben gefahren und es wird weiter gekühlt, bis die Solltemperaturen wieder erreicht sind, dann geht es weiter mit dem Schritt (b1).

Weiterhin wird während des Ladens in einem Schritt (c) der aktuell im MR-Magnetspulensystem 12 fließenden elektrischen Stroms $I_{coil}$ gemessen und verglichen mit einem vorgebbaren ersten Stromsollwert $I_{1target}$, bei welchem das MR-Magnetspulensystem 12 eine gewünschte Magnetfeldstärke erzeugt.

Um eine verbesserte Kühlleistung während des Ladens zu erzielen, insbesondere wenn der Ladestrom über einen Sollwert steigt und das Risiko für ein Aufheizen der Supraleiter führt, wird in Zwischenschritten (c0') und (c0") die Vakuumpumpe 20 aktiviert und das erste Absperrventil 27 geöffnet, sodass flüssiges Helium aus dem Halsrohr abgepumpt wird. Es kann während des Pumpens mit dem Laden fortgefahren werden.

Optional (d) können die Schritte (b1), (b2) und (c) solange wiederholt werden, bis $I_{coil}$ = $I_{1target}$. Wenn dieser Zustand erreicht ist, erfolgt das thermische Überschwingen in den Schritten (d1) durch Stoppen der Kühlung und (d2) Überwachen der Temperatur. Sobald $T_{coil}$ = $T2_{tov}$ erreicht ist, wird die Kühlung wieder angefahren (d3). Anschließend ist der Magnet auf Spec und das Strombeladungsprogramm wird in Schritt (e) beendet.

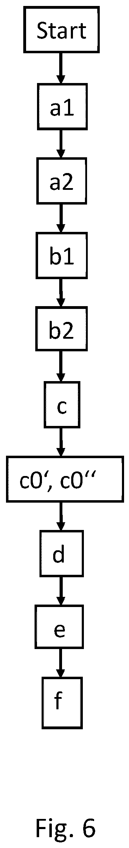

In **Fig. 6** ist ein schematisiertes Flussdiagramm des erfindungsgemäßen autonomen Ladeverfahrens mit den Verfahrensschritten gemäß der Ansprüche für Ausführungsformen mit drei Ventilen dargestellt.

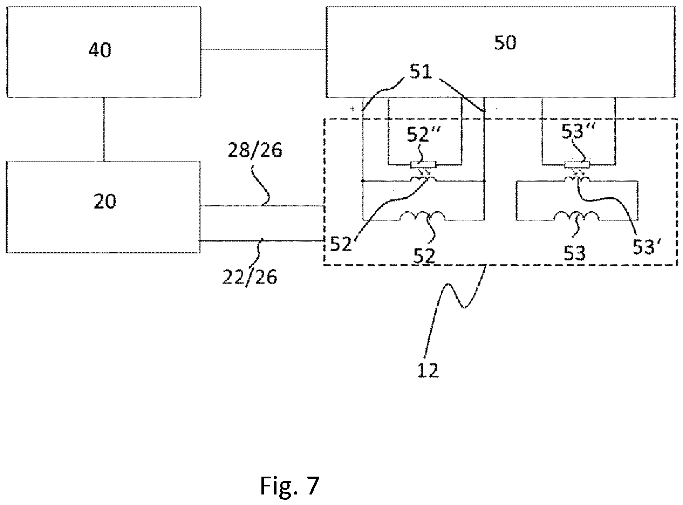

**Fig. 7** zeigt den Aufbau-Schema einer Vorrichtung zum erfindungsgemäßen autonomen elektrischen Laden des supraleitfähigen MR-Magnetspulensystems 12 einer MR-Apparatur 10 mit einem schematisch dargestelltem Spulensystem umfassend eine **Hauptspule 52** mit einem **Hauptschalter 52'** und einem **Hauptheizer 52"** sowie eine **Schirmspule 53** mit einem **Schirmschalter 53'** und einem **Schirmheizer 53",** mit einem Lade-Netzgerät 50, mit Stromstäben 51, mit einer Pumpeneinheit, welche eine oder mehrere Vakuumpumpen 20 aufweist, und mit einer Kontrolleinheit 40 zur Steuerung des Ladevorgangs.

Normalerweise wird das Magnet-Ladegerät 50 über eine Schnittstelle via Ethernet angesteuert. Um die Hauptspule 52 zu laden, muss der Hauptschalter 52' geöffnet werden, was durch Heizen eines Teils der Hauptspule 52 durch den Hauptheizer 52" geschieht. Der geheizte Teil verliert dadurch die Supraleitung und der Hauptschalter 52' ist offen. Entsprechend wird der Hauptschalter 52' geschlossen, wenn der Ladeprozess beendet ist, um die supraleitende Hauptspule 52 kurzzuschließen. Auch beim Unterbrechen des Ladevorgangs, z.B. bei Überschreiten einer vorgegebenen Spulentemperatur oder Schildtemperatur, wird der Hauptschalter 52' geschlossen, bevor der Strom aus den Stromstäben gefahren wird.

Die Schirmspule 53 dient dazu, externe Feldstörungen zu kompensieren. Während des Lade-/Entladevorgangs würde sich die Schirmspule 53 induktiv aufladen bis zu einem Quench. Um dies zu verhindern, wird während des Ladens und Entladens die Schirmspule 53 über den Schirmschalter 53' geöffnet, was durch das Heizen des Schirmheizers 53" geschieht.

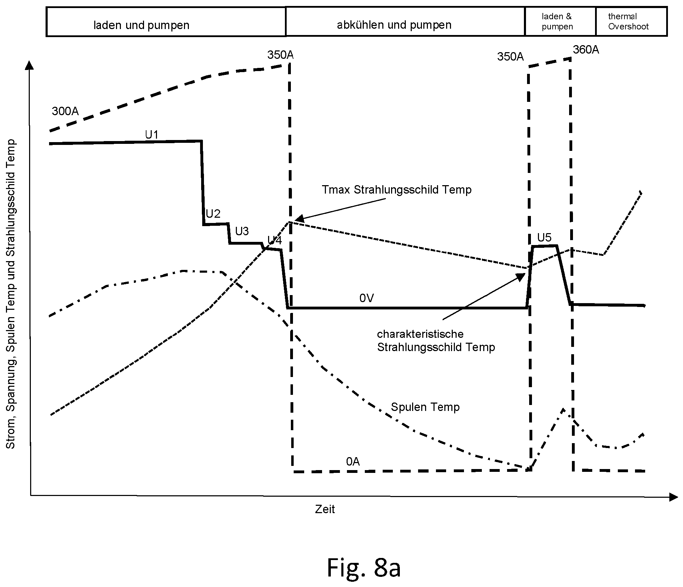

**Fig. 8a** stellt schematisch den Zeitablauf bei der Verfahrensvariante *"Parkieren bei Erreichen einer maximal vorgegebenen Strahlungsschildtemperatur"* dar.

Dabei ist ein typischer Ladevorgang mit Pumpen während des Ladens dargestellt. Die dick gestrichelte Kurve zeigt den Ladestrom, während die Ladespannung wird durch die durchgehende Kurve repräsentiert wird. Dünn gestrichelt ist die Strahlungsschildtemperatur $T_{istshield}$ und strichpunktiert ist die Spulentemperatur $T_{coil}$ dargestellt.

Durch das Pumpen beim Laden werden die Ladeverluste soweit kompensiert, dass ein leichter Spulentemperaturanstieg zu erkennen ist. Das Laden erfolgt stufenweise bei unterschiedlichen Spannungen U1, U2, U3 und U4. Durch Reduzieren der Ladespannung werden weitere Ladeverluste minimiert, somit sinkt die Spulentemperatur weiter. Mit zunehmendem Ladestrom steigt aber auch die Strahlungsschildtemperatur $T_{istshield}$, da die (praktisch immer als HTS-Teil ausgeführte) Stromzuführung am Strahlungsschild 55 thermisch angekoppelt ist. Bei Überschreiten des Grenzwerts von $T_{max}$ am Strahlungsschild 55, in diesem Fall bei einem Ladestrom von 350A, wird der Magnet vom Lade-Algorithmus parkiert: Die supraleitenden Schalter 52', 53' schließen, Strom wird aus den Zuleitungen gefahren. Dabei kühlt der Magnet und damit auch die Strahlungsschildtemperatur $T_{istshield}$ ab. Es wird nach wie vor am Halsrohr 14 gepumpt, um den Abkühlprozess zu beschleunigen. Sobald die charakteristische Strahlungsschildtemperatur erreicht ist, wird der Ladevorgang wieder aktiviert, bis der Strom-Sollwert $I_{Target}$ erreicht ist. Anschließend erfolgt das "thermische Überschwingen".

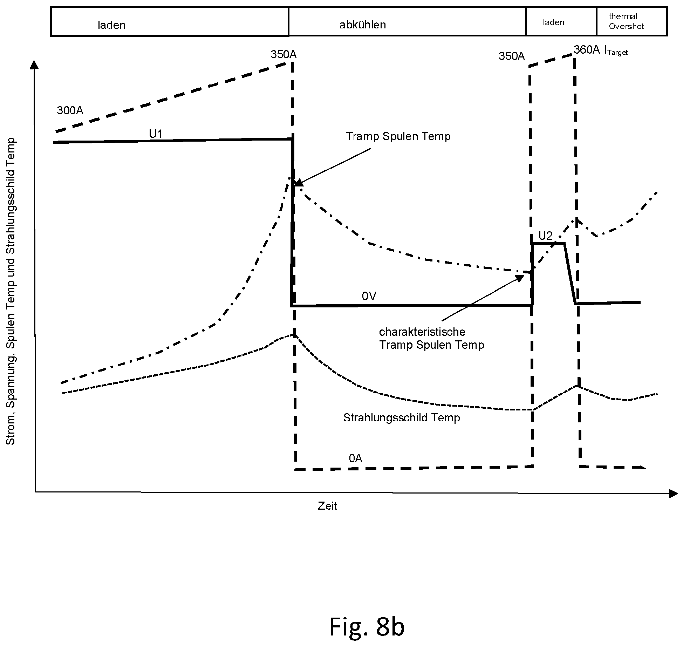

**Fig. 8b** stellt schematisch ein entsprechendes Zeitdiagramm für die Verfahrensvariante *"Parkieren bei Erreichen einer maximal vorgegebenen Spulentemperatur"* dar. Gezeigt ist eine ähnliche Kurve wie in Fig. 8a, nur wird hier bei einer konstanten Ladespannung U1 geladen, was zu einer kontinuierlichen Steigerung der Spulentemperatur führt bis zu $T_{coil}$ = $T_{ramp}$. In diesem Beispiel wird als Unterbrechung ("Parkierungs")-Kriterium die Spulentemperatur $T_{ramp}$ herangezogen. Hier erfolgt der Abkühlvorgang während der Ladeunterbrechung ohne Abpumpen des Heliums im Halsrohr. Diese Variante wird bevorzugt bei kleineren Magneten (<9T) angewendet.

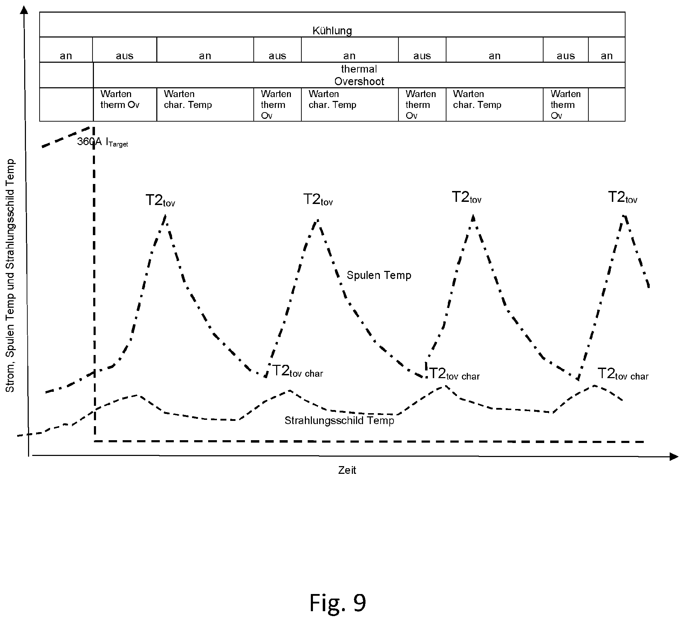

**Fig. 9** zeigt ein schematisches Zeitdiagramm für eine Verfahrensvariante des erfindungsgemäßen Auto-Loading-Verfahrens mit mehrfachem thermischen Überschwingen (=*"thermal overshooting"*).

Nach Erreichen des vorgegebenen ersten Stromsollwert $I_{1target}$, bei welchem das MR-Magnetspulensystem 12 eine gewünschte Magnetfeldstärke erzeugt, wird die Verfahrensvariante des thermischen Überschwingens durchgeführt. Im gezeigten Ausführungsbeispiel werden mehrere thermische Overshoots -hier insgesamt vier- durchlaufen. Dabei wird durch Deaktivieren der Kühlung die Spulentemperatur $T_{coil}$ jeweils auf den vorgegebenen zweiten Temperatursollwert $T2_{tov} < Tc$ erhöht, bei welchem die supraleitende Stromtragfähigkeit des MR-Magnetspulensystems 12 auf einen gewünschten niedrigeren Wert herabgesetzt wird, ohne dass die Supraleitung im Magnetspulensystem 12 die kritische Übergangstemperatur Tc am Übergang vom normalleitenden in den supraleitenden Zustand überschreitet und vollständig zusammenbricht. Diese angestrebte Maximaltemperatur $T2_{tov}$ ist nahe an der kritischen Übergangstemperatur Tc, jedoch mit einem Sicherheitsabstand, in der Regel in der Größenordnung von etwa 100mK.

Mit jedem thermischen Overshoot-Zyklus wird der Supraleiter des MR-Magnetspulensystems 12 etwas stärker ausgelastet, was letztlich zu einer optimierten Stromverteilung in den supraleitenden Filamenten führt. Somit wird die spezifizierte Drift des MR-Magnetspulensystems 12 viel schneller erreicht als z.B. bei badgekühlten Magnetsystemen oder bei Systemen ohne Anwendung des thermischen Überschwingens.

Alternativ wäre es möglich, die Spulentemperatur über längere Zeit bei der Maximaltemperatur $T2_{tov}$ zu halten, anstatt mehrere Overshoot-Zyklen zu fahren. Jedoch ist diese Alternative weniger praktikabel, da die eingesetzten Kaltköpfe nicht dazu geeignet sind, eine konstante Temperatur zu halten.

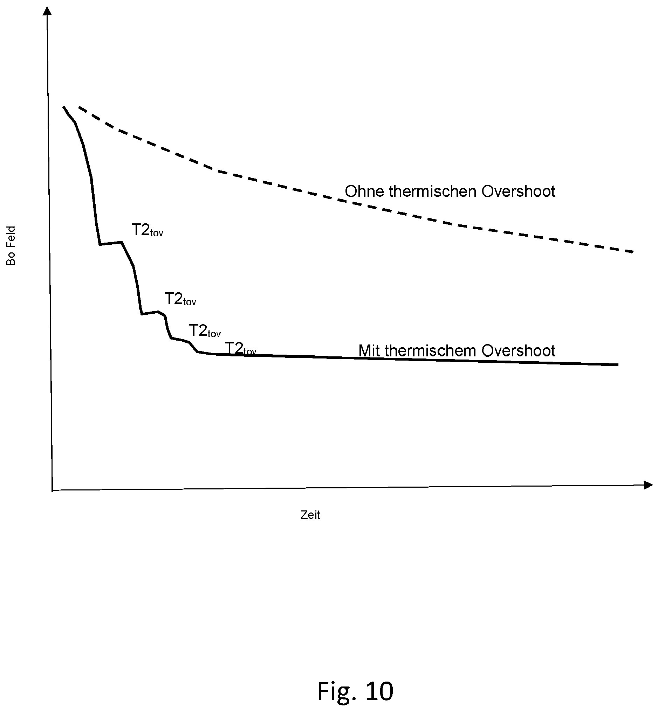

**Fig. 10** schließlich stellt den zeitlichen Ablauf des Driftverhaltens eines MR-Magnetspulensystems 12 nach dem Laden mit und ohne thermisches Überschwingen dar:

Nach dem Laden eines supraleitenden Magneten im "persistent mode" setzt typischerweise ein zeitliches Abklingverhalten des Magnetfelds ein. Dies kann in der Regel mit Umkopplungen in den supraleitenden Filamenten erklärt werden. Erst danach stellt sich das Leiter- und Joint-bedingte Driftverhalten mit typischen Werten von weniger als 0,05ppm/h ein. Dieses "natürliche" Abklingverhalten kann allerdings je nach Magnettyp und Leitertyp mehrere Tage bzw. Wochen andauern. Mit einem gezielt angewendeten thermischen Überschwingen kann dieses Abklingverhalten deutlich verkürzt werden und man erreicht die typischen Langzeit-Driftwerte je nach Magnetsystem in wenigen Stunden. Im beispielhaft in Fig. 10 dargestellten Verlauf mit thermischem Überschwingen sind die multiplen, in diesem Beispiel vier, Overshoots Steps deutlich sichtbar.

**Bezugszeichenliste:**

| | |
|---|---|
| 10 | Magnetresonanz (="MR")-Apparatur |
| 11 | Vakuumbehälter |
| 12 | MR-Magnetspulensystem |
| 13 | Kryostat |
| 13a | Kompressor |
| 14 | Halsrohr |
| 15 | Außenmantel |
| 16 | Kühlarm |
| 17 | Kaltkopf |
| 18 | Hohlraum |
| 19 | kryogenes Fluid |
| 20 | Vakuumpumpe |
| 20a | Turbomolekularpumpe |
| 20b | Vorpumpe |
| 21 | Absperrventil (V3) |
| 22 | Vakuumleitung |
| 23 | Temperatursensor |
| 24 | erster Drucksensor |
| 25 | zweiter Drucksensor |
| 26 | Verbindungsleitung (vom Halsrohr zur Vakuumpumpe) |
| 27 | Absperrventil (V2) |
| 28 | Verbindungsleitung (von Heliumzufuhr zum Halsrohr) |
| 29 | Heliumzufuhr |
| 30 | Absperrventil (V1) |
| 40 | Kontrolleinheit |
| 50 | Lade-Netzgerät |
| 51 | Stromstäbe |
| 52 | Hauptspule |
| 52' | Hauptschalter |
| 52" | Hauptheizer |
| 53 | Schirmspule |

53' Schirmschalter

53" Schirmheizer

55 Strahlungsschild

56 Temperatursensor

**Referenzliste**

Für die Beurteilung der Patentfähigkeit in Betracht gezogene Publikationen:

[0] US 10 060 995 B2
[1] DE 10 2016 218 000 B3 ≈ WO 2018/054648 A1 ≈ EP 3 296 669 B1 ≈ CN 107845474 B ≈ JP 6338755 B ≈ US 10 101 420 B2
[2] US 8 729 894 B2
[3] US 2005/0111159 A1
[4] DE 10 2014 218 773 B4 ≈ CN 105501679 B ≈ GB 2532322 B ≈ US 10 203 067 B2
[5] DE 10 2015 215 919 B4 ≈ GB 2542667 B ≈ US 10 203 068 B2
[6] US 2021/0080527 A1
[7] DE 10 2021 206 392.6

**Patentansprüche**

1. Verfahren zum Betrieb einer Magnetresonanz(="MR")-Apparatur (10) mit einem in einem Vakuumbehälter (11) angeordneten, im MR-Messbetrieb trockenen (="Kryogen-freien"), supraleitfähigen MR-Magnetspulensystem (12) sowie mit einem Kryostaten (13) zum Kühlen des MR-Magnetspulensystems (12), welcher ein Halsrohr (14) umfasst, das durch einen Außenmantel (15) des Vakuumbehälters (11) hindurch zum MR-Magnetspulensystem (12) führt, wobei ein Kühlarm (16) eines Kaltkopfes (17) zumindest teilweise im Halsrohr (14) angeordnet ist, und wobei das supraleitfähige MR-Magnetspulensystem (12) vor einem Beschicken mit einem elektrischen Ladestrom auf eine supraleitende Temperatur gekühlt wird,

   **mit folgenden Schritten**
   zum autonomen elektrischen Laden des supraleitfähigen MR-Magnetspulensystems (12):

   (a1) Initiieren eines Kühlvorgangs des supraleitfähigen MR-Magnetspulensystems (12);
   (a2) Initiieren eines automatischen Strombeladungsprogramms für das supraleitfähige MR-Magnetspulensystem (12);
   (b1) Messen der aktuellen Temperatur $T_{coil}$ am MR-Magnetspulensystem (12) und Vergleichen von $T_{coil}$ mit einem vorgebbaren ersten Temperatursollwert $T1_{ramp}$, ab welchem das MR-Magnetspulensystem (12) supraleitend ist und geladen werden soll, sowie Messen der aktuellen Temperatur $T_{istshield}$ an einem Strahlungsschild (55) und Vergleichen von $T_{istshield}$ mit einem vorgebbaren ersten Temperatursollwert $T_{shield}$;
   (b2) falls $T_{coil} \leq T1_{ramp}$ und falls $T_{istshield} \leq T_{shield}$:
   Zuführen eines Ladestroms in das MR-Magnetspulensystem (12) und Aufladen des MR-Magnetspulensystems (12) mit elektrischem Strom;
   (c) Messen des aktuell im MR-Magnetspulensystem (12) fließenden elektrischen Stroms $I_{coil}$ und Vergleichen von $I_{coil}$ mit einem vorgebbaren ersten Stromsollwert $I1_{target}$, bei welchem das MR-Magnetspulensystem (12) eine gewünschte Magnetfeldstärke erzeugt;
   (d) Wiederholen der Schritte (b1), (b2) und (c) solange, bis $I_{coil} = I1_{target}$;
   (e) Deaktivieren der Stromzufuhr in das MR-Magnetspulensystem (12) und Stoppen des automatischen Strombeladungsprogramms.

2. Verfahren nach Anspruch 1, **dadurch gekennzeichnet, dass** folgende Zwischenschritte zwischen Schritt (d) und Schritt (e) durchgeführt werden:

   (d1) sobald $I_{coil} = I1_{target}$: Stoppen des Kühlvorgangs des supraleitfähigen MR-Magnetspulensystems (12);
   (d2) Messen der aktuellen Temperatur $T_{coil}$ am MR-Magnetspulensystem (12) und Vergleichen von $T_{coil}$ mit einem vorgebbaren zweiten Temperatursollwert $T2_{tov} < Tc$, bei welchem die supraleitende Stromtragfähigkeit des MR-Magnetspulensystems (12) auf einen vorgebbaren niedrigeren Wert herabgesetzt wird, ohne dass die Supraleitung im Magnetspulensystem (12) die kritische Übergangstemperatur Tc am Übergang vom normalleitenden in den supraleitenden Zustand überschreitet und vollständig zusammenbricht;
   (d3) sobald $T_{coil} = T2_{tov}$: Wiederanfahren des Kühlvorgangs des supraleitfähigen MR-Magnetspulensystems (12).

3. Verfahren nach Anspruch 2, **dadurch gekennzeichnet, dass** die Schritte (d1) bis (d3) nach dem Erreichen des Kriteriums $T_{coil} = T2_{tov}$ in Schritt (d3) mehrmals wiederholt werden.

4. Verfahren nach einem der vorhergehenden Ansprüche, **dadurch gekennzeichnet, dass** falls $T_{coil} >$

$T1_{ramp}$ in Schritt (b2) das Aufladen des MR-Magnetspulensystems (12) mit elektrischem Strom unterbrochen und der Kühlvorgang weitergeführt wird bis $T_{coil} \leq T1_{ramp}$; danach erfolgt die Wiederaufnahme in Schritt (b1).

5. Verfahren nach einem der vorhergehenden Ansprüche, **dadurch gekennzeichnet, dass** um den Kühlarm (16) herum ein abgeschlossener Hohlraum (18) ausgebildet ist, der gegenüber dem zu kühlenden MR-Magnetspulensystem (12) fluiddicht abgedichtet und im Normalbetrieb der MR-Apparatur (10) zumindest teilweise mit flüssigem Helium (19) gefüllt ist, dass das Halsrohr (14) über ein erstes Ventil V1 (30) mit einer Heliumgaszufuhr (29) verbunden ist, durch welches einerseits Heliumgas eingeleitet werden kann, um am Kühlarm verflüssigt zu werden, und anderseits, dass das Helium im Halsrohr (14) während der Schritte (c) und (d), abgepumpt wird mit folgenden Schritten

> (c0') Messen des aktuell im MR-Magnetspulensystem (12) fließenden elektrischen Stroms $I_{coil}$ und Vergleichen von $I_{coil}$ mit einem vorgebbaren zweiten Stromsollwert $I2_{pump} < I1_{target}$, ab welchem das Helium im Halsrohr (14) abgepumpt werden soll; und
> (c0") sobald $I_{coil} \geq I2_{pump}$: Aktivieren einer außerhalb des Vakuumbehälters (11) angeordneten Vakuumpumpe (20), Öffnen des ersten Absperrventils (27) in einer von der Vakuumpumpe (20) in das Halsrohr (14) führenden Abpumpleitung (26), um mit der Vakuumpumpe (20) Heliumgas aus dem Halsrohr zu pumpen.

6. Verfahren nach Anspruch 5, **dadurch gekennzeichnet, dass** die Zufuhrleitung (26) zum Halsrohr (14) über ein weiteres Ventil V3 (30) mit der Vakuumpumpe (20) verbunden ist, und dass in einem Schritt (f) Helium in das Halsrohr (14) zugeführt und verflüssigt wird.

7. Verfahren nach einem der vorhergehenden Ansprüche, **dadurch gekennzeichnet, dass** falls $T_{istshield} > T_{shield}$ das Aufladen des MR-Magnetspulensystems (12) mit elektrischem Strom in Schritt (b2) unterbrochen und der Kühlvorgang weitergeführt wird bis $T_{istshield} \leq T_{shield}$, danach erfolgt die Wiederaufnahme des Verfahrens in Schritt (b1).

8. Verfahren nach einem der vorhergehenden Ansprüche, **dadurch gekennzeichnet, dass** die vorgebbaren Temperatursollwerte $T1_{ramp}$ und $T2_{tov}$ sowie die vorgebbaren Stromsollwerte $I1_{target}$ und $I2_{pump}$ aus folgenden Wertebereichen ausgewählt werden:

$$2K < T1_{ramp} \leq 5K,$$

vorzugsweise etwa 4,2K;

$$2K \leq T2_{tov} < 6K,$$

vorzugsweise etwa 4,2K;

$$50A < I1_{target} \leq 500A,$$

vorzugsweise etwa 250A

$$30A \leq I2_{pump} < 400A,$$

vorzugsweise etwa 350A

$$30K \leq T_{shield} < 77K,$$

vorzugsweise etwa 65K.

9. Verfahren nach einem der vorhergehenden Ansprüche, **dadurch gekennzeichnet, dass** der autonome elektrische Ladevorgang des supraleitfähigen MR-Magnetspulensystems (12) mittels einer elektronischen Kontrolleinheit (40) automatisch geregelt wird, wobei die Kontrolleinheit (40) zum Erfassen und Vergleichen der aktuellen Temperatur $T_{coil}$ am MR-Magnetspulensystem (12) mit vorgegebenen Temperatursollwerten, zum Erfassen und Vergleichen des aktuell im MR-Magnetspulensystem (12) fließenden elektrischen Stroms $I_{coil}$ mit vorgegebenen Stromsollwerten sowie gegebenenfalls zur Ansteuerung von Ventilen (21; 27; 30), eines Lade-Netzgeräts (50), einer Vakuumpumpe (20) und Funktionseinheiten des Kaltkopfes (17) konfiguriert ist.

10. Verfahren nach Anspruch 9, **dadurch gekennzeichnet, dass** die elektronische Kontrolleinheit (40) den autonomen elektrischen Ladevorgang des supraleitfähigen MR-Magnetspulensystems (12) mittels eines Algorithmus unter Berücksichtigung diverser Messwerte und Parameter selbsttätig in Abwesenheit von Bedienungs- oder Überwachungspersonal, auch über Nacht, insbesondere über mehrere Tage hinweg, ohne zeitliche Unterbrechung komplett automatisch regelt, und dass die elektronische Kontrolleinheit (40) während des autonomen elektrischen Ladevorgangs des supraleitfähigen MR-Magnetspulensystems (12) selbständig kritische Zustandsänderungen und Störungen des supraleitfähigen MR-Magnetspulensystems (12) sowie des Kryostaten (13) zum Kühlen des MR-Magnetspulensystems (12), insbesondere der Temperaturen, Ströme und Druckwerte im Vakuumbehälter (11) erkennt und darauf entweder durch Einsatz eines vorgebbaren alternativen Algorithmus zur weiteren Regelung des autonomen elektrischen Ladevorgangs und/oder durch Senden von Nachrichten oder Fehlermeldungen, beispielsweise Email-Botschaften, an Bedienungs- oder Überwachungspersonal reagiert.

11. Verfahren nach einem der Ansprüche 9 oder 10, **dadurch gekennzeichnet, dass** die elektronische Kontrolleinheit (40) Zugriff auf mindestens einen Algorithmus zum autonomen elektrischen Entladen oder Teilentladen des supraleitfähigen MR-Magnetspulensystems (12) aus einem elektrisch beladenen Zustand heraus hat, und dass der Entladevorgang mit voreinstellbaren Randbedingungen komplett automatisch durch die elektronische Kontrolleinheit (40) geregelt wird.

12. Magnetresonanz(="MR")-Apparatur (10) zur Durchführung des Verfahrens nach einem der Ansprüche 1 bis 11,

mit einem in einem Vakuumbehälter (11) angeordneten, im MR-Messbetrieb trockenen(="Kryogen-freien"), supraleitfähigen MR-Magnetspulensystem (12) sowie mit einem Kryostaten (13) zum Kühlen des MR-Magnetspulensystems (12), welcher ein Halsrohr (14) umfasst, das durch einen Außenmantel (15) des Vakuumbehälters (11) hindurch zum MR-Magnetspulensystem (12) führt, wobei ein Kühlarm (16) eines Kaltkopfes (17) zumindest teilweise im Halsrohr (14) angeordnet ist, wobei um den Kühlarm (16) herum ein abgeschlossener Hohlraum (18) ausgebildet ist, der gegenüber dem zu kühlenden MR-Magnetspulensystem (12) fluiddicht abgedichtet und im Normalbetrieb der MR-Apparatur (10) zumindest teilweise mit einem kryogenen Fluid (19) gefüllt ist, wobei außerhalb des Vakuumbehälters (11) eine Vakuumpumpe (20) als Teil der MR-Apparatur (10) sowie ein erstes Absperrventil (21) in einer von der Vakuumpumpe (20) in den Vakuumbehälter (11) führenden Vakuumleitung (22) angeordnet sind, wobei ein Temperatursensor (23) zur Messung einer aktuellen Temperatur $T_{coil}$ am MR-Magnetspulensystem (12), ein Temperatursensor (56) zur Messung einer aktuellen Temperatur $T_{shield}$ am Strahlungsschild (55) sowie ein erster Drucksensor (24) zur Messung eines aktuellen Drucks $P_{ist}$ im Vakuumbehälter (11) vorhanden sind, und mit einer Kontrolleinheit gemäß Anspruch 13.

13. Kontrolleinheit (40) zur Verwendung in einer MR-Apparatur (10) mit einem in einem Vakuumbehälter angeordneten, im MR-Messbetrieb trockenen, supraleitfähigen MR-Magnetspulensystem sowie mit einem Kryostaten zum Kühlen des MR-Magnetspulensystems, welcher ein Halsrohr umfasst, das durch einen Außenmantel des Vakuumbehälters hindurch zum MR-Magnetspulensystem führt, wobei ein Kühlarm eines Kaltkopfes zumindest teilweise im Halsrohr angeordnet ist, wobei um den Kühlarm herum ein abgeschlossener Hohlraum ausgebildet ist, der gegenüber dem zu kühlenden MR-Magnetspulensystem fluiddicht abgedichtet und im Normalbetrieb der MR-Apparatur zumindest teilweise mit einem kryogenen Fluid gefüllt ist, wobei außerhalb des Vakuumbehälters eine Vakuumpumpe als Teil der MR-Apparatur sowie ein erstes Absperrventil in einer von der Vakuumpumpe in den Vakuumbehälter führenden Vakuumleitung angeordnet sind, wobei ein Temperatursensor zur Messung einer aktuellen Temperatur $T_{coil}$ am MR-Magnetspulensystem, ein Temperatursensor zur Messung einer aktuellen Temperatur $T_{shield}$ am Strahlungsschild sowie ein erster Drucksensor zur Messung eines aktuellen Drucks $P_{ist}$ im Vakuumbehälter vorhanden sind,

wobei die Kontrolleinheit (40) konfiguriert ist zur Durchführung des Verfahrens nach einem der Ansprüche 1 bis 11, wobei die Kontrolleinheit (40) ein automatisches Strombeladungsprogramm umfasst und zum Erfassen und Vergleichen einer aktuellen Temperatur $T_{coil}$ am MR-Magnetspulensystem (12) mit vorgegebenen Temperatursollwerten, sowie zum Erfassen und Vergleichen eines aktuellen Drucks $P_{ist}$ im Vakuumbehälter (11) mit vorgegebenen Drucksollwerten konfiguriert ist, wobei die Kontrolleinheit (40) eine Messeinheit aufweist, an welche -als Teil der Messeinheit- ein Temperatursensor (23) zur Messung der aktuellen Temperatur $T_{coil}$ am MR-Magnetspulensystem (12) sowie ein Drucksensor (24) zur Messung des aktuellen Drucks $P_{ist}$ im Vakuumbehälter (11) angeschlossen sind, wobei die Kontrolleinheit (40) eine Ansteuereinheit zum Öffnen und Schließen des ersten Absperrventils (21), zur Aktivierung und Deaktivierung der Vakuumpumpe (20) sowie zur Aktivierung und Deaktivierung des Kaltkopfes (17) umfasst.

14. Kontrolleinheit nach Anspruch 13, wobei in der MR-Apparatur (10) eine Verbindung (26) vom Halsrohr (14) zur Vakuumpumpe (20) vorhanden ist, **dadurch gekennzeichnet, dass** die Kontrolleinheit (40) so konfiguriert ist, dass sie die Steuerung eines in der MR-Apparatur (10) vorhandenen Absperrventils V2 (27) zur Vakuumpumpe (20) regelt, dass in der MR-Apparatur (10) eine Verbindung (28) von einer Heliumzufuhr (29) zum Halsrohr (14) vorhanden ist, und dass die Kontrolleinheit (40) so konfiguriert ist, dass sie die Steuerung der He-Zufuhr (29) über das Ventil (30) regelt.

**Claims**

1.  Method for operating a magnetic resonance (="MR") apparatus (10) with a super-conductive MR magnet coil system (12) which is arranged in a vacuum container (11) and is dry (="cryogen-free") in MR measuring mode, and with a cryostat (13) for cooling the MR magnet coil system (12), which comprises a neck tube (14) that leads through an outer casing (15) of the vacuum container (11) to the MR magnet coil system (12), wherein a cooling arm (16) of a cold head (17) is arranged at least partially in the neck tube (14), and wherein the super-conductive MR magnet coil system (12) is cooled to a super-conductive temperature before being supplied with an electrical charging current,

    **comprising the following steps**
    for autonomous electrical charging of the super-conductive MR magnet coil system (12):

    (a1) initiating a cooling operation of the super-conductive MR magnet coil system (12);
    (a2) initiating an automatic current charging program for the super-conductive MR magnet coil system (12);
    (b1) measuring the actual temperature $T_{coil}$ on the MR magnet coil system (12) and comparing $T_{coil}$ with a predefinable first temperature setpoint value $T1_{ramp}$ as of which the MR magnet coil system (12) is super-conductive and should be charged, as well as measuring the actual temperature $T_{istshield}$ on a radiation shield (55) and comparing $T_{istshield}$ with a predefinable first temperature setpoint value $T_{shield}$;
    (b2) if $T_{coil} \leq T1_{ramp}$ and if $T_{istshield} \leq T_{shield}$: supplying a charging current to the MR magnet coil system (12) and charging the MR magnet coil system (12) with electric current;
    (c) measuring the electric current $I_{coil}$ currently flowing in the MR magnet coil system (12) and comparing $I_{coil}$ with a predefinable first current setpoint value $I1_{target}$ at which the MR magnet coil system (12) generates a desired magnetic field strength;
    (d) repeating steps (b1), (b2) and (c) until $I_{coil} = I1_{target}$;
    (e) deactivating the current supply to the MR magnet coil system (12) and stopping the automatic current charging program.

2.  Method according to claim 1, **characterized in that** the following intermediate steps are carried out between step (d) and step (e):

    (d1) as soon as $I_{coil} = I1_{target}$: stopping the cooling operation of the super-conductive MR magnet coil system (12);
    (d2) measuring the actual temperature $T_{coil}$ on the MR magnet coil system (12) and comparing $T_{coil}$ with a predefinable second temperature setpoint value $T2_{tov} < Tc$ at which the super-conductive current carrying capacity of the MR magnet coil system (12) is reduced to a predefinable lower value without the superconductivity in the magnet coil system (12) exceeding the critical transition temperature Tc at the transition from the normal conducting to the super-conductive state and collapsing completely;
    (d3) as soon as $T_{coil} = T2_{tov}$: restarting the cooling operation of the super-conductive MR magnet coil system (12).

3.  Method according to claim 2, **characterized in that** steps (d1) to (d3) are repeated several times after the criterion $T_{coil} = T2_{tov}$ has been reached in step (d3).

4.  Method according to any of the preceding claims, **characterized in that**, if $T_{coil} > T1_{ramp}$, in step (b2) the charging of the MR magnet coil system (12) with electric current is interrupted and the cooling operation is continued until $T_{coil} \leq T1_{ramp}$; then step (b1) is resumed.

5.  Method according to any of the preceding claims, **characterized in that** a closed cavity (18) is formed around the cooling arm (16) and is sealed fluid-tight with respect to the MR magnet coil system (12) to be cooled and is at least partially filled with liquid helium (19) during normal operation of the MR apparatus (10), **in that** the neck tube (14) is connected via a first valve V1 (30) to a helium gas supply (29), through which helium gas can be introduced on the one hand in order to be liquefied on the cooling arm, and on the other hand **in that** the helium in the neck tube (14) is pumped out during steps (c) and (d), with the following steps

    (c0') measuring the electric current $I_{coil}$ currently flowing in the MR magnet coil system (12) and comparing $I_{coil}$ with a predefinable second current setpoint value $I2_{pump} < I1_{target}$ as of which the helium in the neck tube (14) should be pumped out; and
    (c0") as soon as $I_{coil} \geq I2_{pump}$: activating a vacuum pump (20) arranged outside the vacuum container (11), opening the first shut-off valve (27) in a pumping line (26) leading from the vacuum pump (20) into the neck tube (14) in order to pump helium gas out of the neck tube using the vacuum pump (20).

6. Method according to claim 5, **characterized in that** the supply line (26) to the neck tube (14) is connected to the vacuum pump (20) via a further valve V3 (30), and that in a step (f) helium is supplied into the neck tube (14) and liquefied.

7. Method according to any one of the preceding claims, **characterized in that**, if $T_{istshield} > T_{shield}$, the charging of the **MR** magnet coil system (12) with electric current is interrupted in step (b2) and the cooling operation is continued until $T_{istshield} \leq T_{shield}$, after which the method is resumed in step (b1).

8. Method according to any of the preceding claims, **characterized in that** the predefinable temperature setpoint values $T1_{ramp}$ and $T2_{tov}$ and the predefinable current setpoint values $I1_{target}$ and $I2_{pump}$ are selected from the following value ranges:

$$2K < T1_{ramp} \leq 5K,$$

preferably about 4.2K;

$$2K \leq T2_{tov} < 6K,$$

preferably about 4.2K;

$$50A < I1_{target} \leq 500A,$$

preferably about 250A

$$30A \leq I2_{pump} < 400A,$$

preferably about 350A

$$30K \leq T_{shield} < 77K,$$

preferably about 65K.

9. Method according to any of the preceding claims, **characterized in that** the autonomous electrical charging operation of the super-conductive MR magnet coil system (12) is automatically regulated by means of an electronic control unit (40), wherein the control unit (40) is configured to detect and compare the actual temperature $T_{coil}$ on the MR magnet coil system (12) with predefined temperature setpoint values, to detect and compare the electric current $I_{coil}$ currently flowing in the MR magnet coil system (12) with predefined current setpoint values and, if necessary, to actuate valves (21; 27; 30), a charging mains supply unit (50), a vacuum pump (20) and functional units of the cold head (17).

10. Method according to claim 9, **characterized in that** the electronic control unit (40) regulates the autonomous electrical charging operation of the super-conductive MR magnet coil system (12) completely automatically by means of an algorithm taking into account various measured values and parameters on its own in the absence of operating or monitoring personnel, even overnight, in particular over several days, without any time interruption, and **in that**, during the autonomous electrical charging operation of the super-conductive MR magnet coil system (12), the electronic control unit (40) independently detects critical changes in state and errors in the super-conductive MR magnet coil system (12) and in the cryostat (13) for cooling the MR magnet coil system (12), in particular the temperatures, currents and pressure values in the vacuum container (11), and reacts to this either by using a predefinable alternative algorithm for further regulation of the autonomous electrical charging operation and/or by sending messages or error messages, for example email messages, to operating or monitoring personnel.

11. Method according to either of claims 9 or 10, **characterized in that** the electronic control unit (40) has access to at least one algorithm for autonomous electrical discharging or partial discharging of the super-conductive MR magnet coil system (12) from an electrically charged state, and **in that** the discharging operation is regulated completely automatically by the electronic control unit (40) with presettable boundary conditions.

12. Magnetic resonance ("MR") apparatus (10) for carrying out the method according to any of claims 1 to 11,

with a super-conductive MR magnet coil system (12) which is arranged in a vacuum container (11) and is dry (= "cryogen-free") in MR measurement mode, and with a cryostat (13) for cooling the MR magnet coil system (12), which comprises a neck tube (14) which leads through an outer casing (15) of the vacuum container (11) to the MR magnet coil system (12), wherein a cooling arm (16) of a cold head (17) is arranged at least partially in the neck tube (14), wherein a closed cavity (18) is formed around the cooling arm (16) and is sealed fluid-tight with respect to the MR magnet coil system (12) to be cooled and is at least partially filled with a cryogenic fluid (19) during normal operation of the MR apparatus (10),
wherein outside the vacuum container (11) a vacuum pump (20) as part of the MR apparatus (10) and a first shut-off valve (21) are arranged in a vacuum line (22) leading from the vacuum pump (20) into the vacuum container (11),

wherein a temperature sensor (23) is provided for measuring an actual temperature $T_{coil}$ on the MR magnet coil system (12), a temperature sensor (56) is provided for measuring an actual temperature $T_{shield}$ on the radiation shield (55) and a first pressure sensor (24) is provided for measuring an actual pressure $P_{ist}$ in the vacuum container (11),

and with a control unit according to claim 13.

13. Control unit (40) for use in an MR apparatus (10) with a superconductive MR magnet coil system which is arranged in a vacuum container and is dry in MR measuring mode, and with a cryostat for cooling the MR magnet coil system, which comprises a neck tube that leads through an outer casing of the vacuum container to the MR magnet coil system, wherein a cooling arm of a cold head is arranged at least partially in the neck tube, wherein a closed cavity is formed around the cooling arm and is sealed fluid-tight with respect to the MR magnet coil system to be cooled and is at least partially filled with a cryogenic fluid during normal operation of the MR apparatus, wherein outside the vacuum container a vacuum pump as part of the MR apparatus and a first shut-off valve are arranged in a vacuum line leading from the vacuum pump into the vacuum container, wherein a temperature sensor is provided for measuring an actual temperature $T_{coil}$ on the MR magnet coil system, a temperature sensor is provided for measuring an actual temperature $T_{shield}$ on the radiation shield and a first pressure sensor is provided for measuring an actual pressure $P_{ist}$ in the vacuum container,

wherein the control unit (40) is configured to perform the method according to any one of the claims 1 to 11, wherein the control unit (40) comprises an automatic current charging program and is configured to detect and compare an actual temperature $T_{coil}$ on the MR magnet coil system (12) with predefined temperature setpoint values, and to detect and compare an actual pressure $P_{ist}$ in the vacuum container (11) with predefined pressure setpoint values,

wherein the control unit (40) has a measuring unit to which a temperature sensor (23) for measuring the actual temperature $T_{coil}$ on the MR magnet coil system (12) and a pressure sensor (24) for measuring the actual pressure $P_{ist}$ in the vacuum container (11) are connected,

wherein the control unit (40) comprises an actuating unit for opening and closing the first shut-off valve (21), for activating and deactivating the vacuum pump (20) and for activating and deactivating the cold head (17).

14. Control unit according to claim 13, wherein a connection (26) from the neck tube (14) to the vacuum pump (20) is provided in the MR apparatus (10), **characterized in that** the control unit (40) is configured to regulate the control of a shut-off valve V2 (27) provided in the MR apparatus (10) to the vacuum pump (20), **in that** a connection (28) from a helium supply (29) to the neck tube (14) is provided in the MR apparatus (10), and that the control unit (40) is configured to regulate the control of the He supply (29) via the valve (30).

## Revendications

1. Procédé de fonctionnement d'un appareil à résonance magnétique(=« RM ») (10) comprenant un système de bobine magnétique RM supraconductrice (12) à sec (=« sans cryogène ») en mode de mesure RM, agencé dans un réservoir sous vide (11), et comprenant un cryostat (13) permettant de refroidir le système de bobine magnétique RM (12), lequel cryostat comprend un tube à collet (14) menant au système de bobine magnétique RM (12) en passant à travers une enveloppe extérieure (15) du réservoir sous vide (11), un bras de refroidissement (16) d'une tête froide (17) étant agencé au moins partiellement dans le tube à collet (14), et le système de bobine magnétique RM supraconductrice (12) étant refroidi à une température supraconductrice avant d'être chargé d'un courant de charge électrique,

**comprenant les étapes ci-dessous consistant à,**

en vue d'une charge électrique autonome du système de bobine magnétique RM supraconductrice (12) :

(a1) lancer une opération de refroidissement du système de bobine magnétique RM supraconductrice (12) ;

(a2) lancer un programme de charge de courant automatique pour le système de bobine magnétique RM supraconductrice (12) ;

(b1) mesurer la température actuelle $T_{coil}$ au niveau du système de bobine magnétique RM (12) et comparer $T_{coil}$ avec une première valeur de consigne de température $T1_{ramp}$ prédéfinissable à partir de laquelle le système de bobine magnétique RM (12) est supraconducteur et doit être chargé, et mesurer la température actuelle $T_{istshield}$ au niveau d'un bouclier de rayonnement (55) et comparer $T_{istshield}$ avec une première valeur de consigne de température $T_{shield}$ prédéfinissable,

(b2) si $T_{coil} \leq T1_{ramp}$ et si $T_{istshield} \leq T_{shield}$ : fournir un courant de charge au système de bobine magnétique RM (12) et charger le système de bobine magnétique RM (12) avec un courant électrique ;

(c) mesurer le courant électrique $I_{coil}$ circulant actuellement dans le système de bobine magnétique RM (12) et comparer $I_{coil}$ avec une première valeur de consigne de courant $I1_{target}$ prédéfinissable pour laquelle le système de bobine magnétique RM (12) produit une intensité de champ magnétique souhaitée ;

(d) répéter les étapes (b1), (b2) et (c) jusqu'à ce que $I_{coil} = I1_{target}$,

(e) désactiver l'alimentation en courant dans le système de bobine magnétique RM (12) et arrêter le programme de charge de courant automatique.

2. Procédé selon la revendication 1, **caractérisé en ce que** les étapes intermédiaires ci-dessous sont mises en œuvre entre l'étape (d) et l'étape (e) :

(d1) dès que $I_{coil} = I1_{target}$ : arrêter l'opération de refroidissement du système de bobine magnétique RM supraconductrice (12) ;

(d2) mesurer la température actuelle $T_{coil}$ au niveau du système de bobine magnétique RM (12) et comparer $T_{coil}$ avec une deuxième valeur de consigne de température prédéfinissable $T2_{tov} \leq Tc$ pour laquelle la capacité supraconductrice de charge de courant du système de bobine magnétique RM (12) est réduite à une valeur inférieure prédéfinissable sans que la supraconductivité au sein du système de bobine magnétique (12) dépasse la température de transition critique Tc lors de la transition de l'état de conduction normal à l'état supraconducteur et s'effondre complètement ;

(d3) dès que $T_{coil} = T2_{tov}$ : arrêter l'opération de refroidissement du système de bobine magnétique RM supraconductrice (12) ;

3. Procédé selon la revendication 2, **caractérisé en ce que** les étapes (d1) à (d3) sont répétées plusieurs fois après avoir atteint le critère $T_{coil} = T2_{tov}$ à l'étape (d3).

4. Procédé selon l'une quelconque des revendications précédentes, **caractérisé en ce que** si $T_{coil} > T1_{ramp}$ à l'étape (b2), la charge du système de bobine magnétique MR (12) avec un courant électrique est interrompue et l'opération de refroidissement est poursuivie jusqu'à ce que $T_{coil} \leq T1_{ramp}$ ; puis le procédé reprend à l'étape (b1).

5. Procédé selon l'une quelconque des revendications précédentes, **caractérisé en ce qu'**autour du bras de refroidissement (16) est formée une cavité fermée (18) qui est rendue étanche aux fluides par rapport au système de bobine magnétique RM (12) à refroidir et qui est remplie au moins partiellement d'hélium liquide (19) en fonctionnement normal de l'appareil RM (10), **en ce que** le tube à collet (14) est relié par l'intermédiaire d'une première vanne V1 (30) à une alimentation en gaz hélium (29) à travers laquelle, d'une part, du gaz hélium peut être introduit pour être liquéfié au niveau du bras de refroidissement et, d'autre part, **en ce que** l'hélium est pompé dans le tube à collet (14) pendant les étapes (c) et (d), grâce aux étapes ci-dessous consistant à

(c0') mesurer le courant électrique $I_{coil}$ circulant actuellement dans le système de bobine magnétique RM (12) et comparer $I_{coil}$ avec une deuxième valeur de consigne de courant prédéfinissable $I2_{pump} \leq I1_{target}$ à partir de laquelle l'hélium doit être pompé dans le tube à collet (14) ; et

(c0") dès que $I_{coil} \geq I2_{pump}$ : activer une pompe à vide (20) agencée à l'extérieur du réservoir sous vide (11), ouvrir la première vanne d'arrêt (27) dans une conduite de pompage (26) menant de la pompe à vide (20) jusque dans le tube à collet (14) afin de pomper du gaz hélium hors du tube à collet avec la pompe à vide (20).

6. Procédé selon la revendication 5, **caractérisé en ce que** la conduite d'alimentation (26) menant au tube à collet (14) est reliée à la pompe à vide (20) par l'intermédiaire d'une vanne V3 (30) supplémentaire, et **en ce que** de l'hélium est acheminé et liquéfié dans le tube à collet (14) lors d'une étape (f).

7. Procédé selon l'une quelconque des revendications précédentes, **caractérisé en ce que** si $T_{istshield} > T_{shield}$, la charge du système de bobine magnétique MR (12) avec un courant électrique lors de l'étape (b2) est interrompue et l'opération de refroidissement est poursuivie jusqu'à ce que $T_{istshield} \leq T_{shield}$, puis le procédé reprend à l'étape (b1).

8. Procédé selon l'une quelconque des revendications précédentes, **caractérisé en ce que** les valeurs de consigne de température prédéfinissables $T1_{ramp}$ et $T2_{tov}$ ainsi que les valeurs de consigne de courant prédéfinissables $I1_{target}$ et $I2_{pump}$ sont sélectionnées parmi les plages de valeurs ci-dessous :

$$2K < T1_{ramp} \leq 5K,$$

de manière préférée environ 4,2K ;

$$2K \leq T2_{tov} \leq 6K,$$

de manière préférée environ 4,2K ;

$$50A \leq I1_{target} \leq 500A,$$

de manière préférée environ 250A

$$30A \leq I2_{pump} < 400A,$$

de manière préférée environ 350A

$$30K \leq T_{shield} < 77K,$$

de manière préférée environ 65K.

9. Procédé selon l'une quelconque des revendications précédentes, **caractérisé en ce que** l'opération de charge électrique autonome du système de bobine magnétique RM supraconductrice (12) est régulé automatiquement au moyen d'une unité de contrôle électronique (40), l'unité de contrôle (40) étant configurée pour détecter et comparer la température actuelle $T_{coil}$ au niveau du système de bobine magnétique RM (12) avec des valeurs de consigne de température prédéfinies, pour détecter et comparer le courant électrique $I_{coil}$ circulant actuellement dans le système de bobine magnétique RM (12) avec des valeurs de consigne de courant prédéfinies et, le cas échéant, pour commander des vannes (21 ; 27 ; 30), un appareil secteur de charge (50), une pompe à vide (20) et des unités fonctionnelles de la tête froide (17).

10. Procédé selon la revendication 9, **caractérisé en ce que** l'unité de contrôle électronique (40) régule de manière complètement automatique l'opération de charge électrique autonome du système de bobine magnétique RM supraconductrice (12) au moyen d'un algorithme en tenant compte de diverses valeurs de mesure et divers paramètres en l'absence de personnel d'exploitation ou de surveillance, même pendant la nuit, en particulier pendant plusieurs jours, sans interruption temporelle, et **en ce que**, pendant l'opération de charge électrique autonome du système de bobine magnétique RM supraconductrice (12), l'unité de contrôle électronique (40) détecte automatiquement des changements d'état critiques et des perturbations du système de bobine magnétique RM supraconductrice (12) et du cryostat (13) permettant de refroidir le système de bobine magnétique RM (12), en particulier des températures, des courants et des valeurs de pression au sein du réservoir sous vide (11), et réagit à cela en utilisant une variante d'algorithme prédéfinie afin de continuer à réguler l'opération de charge électrique autonome et/ou en envoyant des messages ou des messages d'erreur, par exemple des messages électroniques, au personnel d'exploitation ou de surveillance.

11. Procédé selon l'une quelconque des revendications 9 ou 10, **caractérisé en ce que** l'unité de contrôle électronique (40) a accès à au moins un algorithme permettant une décharge électrique autonome ou une décharge partielle du système de bobine magnétique RM supraconductrice (12) à partir d'un état chargé électriquement, et **en ce que** l'opération de décharge est régulée de manière complètement automatique grâce à l'unité de contrôle électronique (40) avec des conditions limites préajustables.

12. Appareil à résonance magnétique(=« RM ») (10) permettant la mise en œuvre du procédé selon l'une quelconque des revendications 1 à 11, comprenant un système de bobine magnétique RM supraconductrice (12) à sec (=« sans cryogène ») en mode de mesure RM, agencé dans un réservoir sous vide (11), et un cryostat (13), permettant de refroidir le système de bobine magnétique RM (12), lequel cryostat comprend un tube à collet (14) menant au système de bobine magnétique RM (12) en passant à travers une enveloppe extérieure (15) du réservoir sous vide (11), un bras de refroidissement (16) d'une tête froide (17) étant agencé au moins partiellement dans le tube à collet (14), une cavité fermée (18), rendue étanche aux fluides par rapport au système de bobine magnétique RM (12) à refroidir et remplie au moins partiellement d'un fluide cryogénique (19) en fonctionnement normal de l'appareil RM (10), étant formée autour du bras de refroidissement (16), une pompe à vide (20) faisant partie de l'appareil RM (10) et une première vanne d'arrêt (21) étant agencées à l'extérieur du réservoir sous vide (11) dans une conduite sous vide (22) menant de la pompe à vide (20) jusqu'au réservoir sous vide (11), un capteur de température (23) permettant de mesurer une température actuelle $T_{coil}$ au niveau du système de bobine magnétique RM (12), un capteur de température (56) permettant de mesurer une température actuelle $T_{shield}$ au niveau du bouclier de rayonnement (55) et un premier capteur de pression (24) permettant de mesurer une pression actuelle $P_{ist}$ étant présents dans le réservoir sous vide (11),
et comprenant une unité de contrôle selon la revendication 13.

13. Unité de contrôle (40) à utiliser dans un appareil RM (10) comprenant un système de bobine magnétique RM supraconductrice à sec en mode de mesure RM, agencé dans un réservoir sous vide, et comprenant un cryostat permettant de refroidir le système de bobine magnétique RM, lequel cryostat comprend un tube à collet menant au système de bobine magnétique RM en passant à travers une enveloppe extérieure du réservoir sous vide, un bras de refroidissement d'une tête froide étant agencé au moins partiellement dans le tube à collet, une cavité fermée, rendue étanche aux fluides par rapport au système de bobine magnétique RM à refroidir et remplie au moins partiellement d'un fluide cryogénique en mode normal de l'appareil RM, étant formée autour du bras de refroidissement, une pompe à vide faisant partie de l'appareil RM et une première vanne d'arrêt étant agencées à l'extérieur du réservoir sous vide dans une conduite sous vide menant de la pompe à vide jusque dans le réservoir sous vide, un capteur de température permettant de mesurer une température actuelle $T_{coil}$ au niveau du système de bobine magnétique RM, un capteur de température permettant de mesurer une température actuelle $T_{shield}$ au niveau du bouclier de rayonnement et un premier capteur de pression permettant de mesurer une pression actuelle $P_{ist}$ étant présents dans le réservoir sous vide.

l'unité de contrôle (40) étant configurée pour mettre en œuvre le procédé selon l'une quelconque des revendications 1 à 11, l'unité de contrôle (40) comprenant un programme de charge de courant automatique et étant configurée pour détecter et comparer une température actuelle $T_{coil}$ au niveau du système de bobine magnétique RM (12) avec des valeurs de consigne de température prédéfinies, et pour détecter et comparer une pression actuelle $P_{ist}$ au sein du réservoir sous vide (11) avec des valeurs de consigne de pression prédéfinies, l'unité de contrôle (40) présentant une unité de mesure à laquelle sont raccordés - comme faisant partie de l'unité de mesure - un capteur de température (23) permettant de mesurer la température actuelle $T_{coil}$ au niveau du système de bobine magnétique RM (12) et un capteur de pression (24) permettant de mesurer la pression actuelle $P_{ist}$ au sein du réservoir sous vide (11), l'unité de contrôle (40) comprenant une unité de commande permettant d'ouvrir et de fermer la première vanne d'arrêt (21) afin d'activer et de désactiver la pompe à vide (20) et afin d'activer et de désactiver la tête froide (17).

14. Unité de contrôle selon la revendication 13, une liaison (26) allant du tube à collet (14) jusqu'à la pompe à vide (20) étant présente dans l'appareil RM (10), **caractérisée en ce que** l'unité de contrôle (40) est configurée pour réguler la commande d'une vanne d'arrêt V2 (27) présente dans l'appareil RM (10) et menant à la pompe à vide (20), **en ce qu'**une liaison (28) allant d'une alimentation en hélium (29) jusqu'au tube à collet (14) est présente dans l'appareil RM (10), et **en ce que** l'unité de contrôle (40) est configurée pour réguler la commande de l'alimentation en He (29) par l'intermédiaire de la vanne (30).

EP 4 479 762 B1

Fig. 1

Initialisierung: Magnet laden
Bedingung: - $T_{coil}$ = kalt
         - Kühlung = an
         - Hauptschalter offen

Laden

-Kühlung
-Strom in Stromstäben= 0A

$T_{coil}$ = kritisch ?
$T_{shield}$ = kritisch ?
Kühlung = an ?
Sensoren = OK ?

Quench ?

N

Ladevorgang = aus:
-U = 0V
-Hauptschalter geschlossen

N

J

$I_{target}$ erreicht?

J

Kühlung = aus
bis $T_{coil}$>$T_{tov}$

Thermisches
Überschwingen

Kühlung = an

Feld

Fig. 2

Fig. 3

Fig. 4

Initialisierung: Magnet laden
Bedingung: - $T_{coil}$ = kalt
      - Kühlung = an
      - Hauptschalter offen

Laden

-Kühlung
-Strom in Stromstäben= 0A

$T_{coil}$ = kritisch ?
$T_{shield}$ = kritisch ?
Kühlung = an ?
Sensoren = OK ?

N

Quench ?

Ladevorgang = aus:
-U = 0V
-Hauptschalter geschlossen

J

$I > I_{pump}$?

J

Pumpe = an

N

$I_{target}$ erreicht?

N

J

Kühlung = aus
bis $T_{coil} > T_{tov}$

Kühlung = an

Feld

Fig. 5

Fig. 6

Fig. 7

| laden und pumpen | abkühlen und pumpen | laden & pumpen | thermal Overshoot |
|---|---|---|---|

Fig. 8a

Fig. 8b

| Kühlung | | | | | | | | |
|---|---|---|---|---|---|---|---|---|
| an | aus | an | aus | an | aus | an | aus | an |
| | thermal Overshoot | | | | | | | |
| | Warten therm Ov | Warten char. Temp | Warten therm Ov | Warten char. Temp | Warten therm Ov | Warten char. Temp | Warten therm Ov | |

Fig. 9

Ohne thermischen Overshoot

$T2_{tov}$

$T2_{tov}$

$T2_{tov}$

$T2_{tov}$

Mit thermischem Overshoot

Bo Feld

Zeit

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 10060995 B2
- DE 102016218000 B3
- US 8729894 B2
- US 20050111159 A1
- DE 102014218773 B4
- DE 102015215919 B4
- US 20210080527 A1
- DE 102021206392
- WO 2018054648 A1

- EP 3296669 B1
- CN 107845474 B
- JP 6338755 B
- US 10101420 B2
- CN 105501679 B
- GB 2532322 B
- US 10203067 B2
- GB 2542667 B
- US 10203068 B2